(19) Europäisches Patentamt
European Patent Office
Office européen des brevets

(11) **EP 2 014 611 B1**

(12) **FASCICULE DE BREVET EUROPEEN**

(45) Date de publication et mention
de la délivrance du brevet:
**07.09.2011 Bulletin 2011/36**

(21) Numéro de dépôt: **08159904.5**

(22) Date de dépôt: **08.07.2008**

(51) Int Cl.:
*B81B 3/00* (2006.01)    *B81B 7/02* (2006.01)
*G11C 23/00* (2006.01)    *H01L 21/28* (2006.01)
*H01L 21/336* (2006.01)    *H01L 29/423* (2006.01)
*H01L 29/51* (2006.01)    *H01L 29/68* (2006.01)
*H01L 29/49* (2006.01)    *H01L 29/78* (2006.01)
*H01L 27/20* (2006.01)    *H01L 41/09* (2006.01)

(54) **Transistor MOS à grille suspendue et à fonctionnement non-volatile par actionnement piézoélectrique et son procédé de fabrication**

MOS-Transistor mit frei hängendem Gate und nichtflüchtiger Funktionsweise mit piezoelektrische Aktivierung und Herstellungsverfahren desselben

Suspended-gate MOS transistor with non-volatile operation by piezoelectric activation and manufacturing method thereof

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **09.07.2007 FR 0756347**

(43) Date de publication de la demande:
**14.01.2009 Bulletin 2009/03**

(73) Titulaire: **Commissariat à l'Énergie Atomique et aux Énergies Alternatives**
**75015 Paris (FR)**

(72) Inventeurs:
- **Collonge, Michael**
  **38600, FONTAINE (FR)**
- **Thomas, Olivier**
  **38420, REVEL (FR)**
- **Vinet, Maud**
  **38140, RIVES (FR)**

(74) Mandataire: **Ilgart, Jean-Christophe**
**BREVALEX**
**95 rue d'Amsterdam**
**75378 Paris Cedex 8 (FR)**

(56) Documents cités:
**US-A1- 2006 284 239**

EP 2 014 611 B1

**Description**

## DOMAINE TECHNIQUE

La présente invention se rapporte au domaine de la microélectronique et des circuits intégrés, et plus particulièrement à celui des transistors.

Elle concerne un dispositif microélectronique, doté d'une nouvelle architecture de transistor à grille suspendue, et doté de moyens d'actionnement piézoélectriques de la grille. Ce dispositif présente comme avantage de pouvoir présenter un fonctionnement non-volatile.

L'invention prévoit également un procédé de réalisation d'un tel dispositif.

## ÉTAT DE LA TECHNIQUE ANTÉRIEURE

Il existe des transistors à grille dite « suspendue » pour lesquels, la grille est désolidarisée du canal, et comportant un espace vide entre au moins une partie de la grille et le diélectrique de grille.

Dans un transistor MOS (MOS pour « Métal Oxide Semi-conductor ») à grille suspendue, la grille est désolidarisée de la couche de diélectrique de grille et constitue une structure mobile et/ou déformable.

Un déplacement de la grille dans une direction normale à la surface du diélectrique de grille entraîne une variation des caractéristiques électriques du transistor MOS.

Cet effet a déjà été utilisé dans différentes applications, par exemple pour la réalisation de capteurs tels que des accéléromètres, des capteurs de pression, des capteurs de position, dans lesquels le déplacement et/ou la déformation de la grille est induite par une force mécanique extérieure au capteur, induite par exemple par une accélération ou un déplacement. Dans un accéléromètre, un déplacement peut induire une variation du courant traversant le canal du transistor. Une mesure de cette variation de courant peut permettre alors de remonter à la grandeur que l'on souhaite mesurer à l'aide du capteur. De tels capteurs ont été mis en oeuvre sous forme de MEMS (MEMS pour « Micro Electromechanical Systems » ou Micro-Systèmes Electromécaniques). Avec ces capteurs, le courant dans le canal du transistor varie en temps réel ou en même temps que la sollicitation appliquée à la grille. A l'arrêt de cette force mécanique extérieure, le dispositif revient dans un état de fonctionnement initial, qui sert de référence.

Des dispositifs dans lequel le déplacement et/ou la déformation de la grille est induite à l'aide d'une force électrostatique appliquée sur une grille suspendue sont également apparus.

Les documents [1] et [2] (référencés à la fin de la présente description) proposent la réalisation d'une grille suspendue pour permettre d'améliorer les performances électriques d'un transistor, notamment sa pente sous le seuil.

Le document [2] propose en particulier un transistor à grille suspendue actionnée électrostatiquement, sur un transistor MOS à accumulation. Tout comme dans les structures de transistor MOS fonctionnant en inversion, un tel transistor a un caractère volatile et perd son information à l'arrêt de son alimentation.

Le document [3] propose quant à lui la réalisation de dispositifs RF tels que des résonateurs électro-mécaniques ou des commutateurs à faible tension, comportant des transistors à grille suspendue.

Le document [4] présente quant à lui une cellule mémoire volatile à un seul transistor MOS doté d'une grille suspendue. Dans tous les dispositifs à grille suspendue et dotés d'un actionneur électrostatique, la position de la grille suspendue est susceptible de changer à l'extinction de l'alimentation du dispositif. Le document US 2006/0284239 A1 présente un transistor de cellule de mémoire flash doté d'une grille actionnée par des moyens piézoélectriques et d'une grille flottante. Il est par ailleurs difficile, dans les dispositifs à grille suspendue en général, de concilier des critères de faible dimension de la grille du transistor, et un actionnement aisé de cette dernière.

Il se pose le problème de trouver un nouveau dispositif de transistor à grille suspendue, qui ne présente pas les inconvénients mentionnés plus haut.

## EXPOSÉ DE L'INVENTION

L'invention est définie par les revendications indépendantes et concerne un dispositif microélectronique doté d'au moins un transistor comportant :

- sur un substrat, une zone semi-conductrice de canal recouverte d'une zone de diélectrique de grille,
- une grille mobile, suspendue au-dessus du diélectrique de grille et disjointe du diélectrique de grille, la grille étant située à une distance ajustable de ladite zone de diélectrique de grille,
- des moyens d'actionnement piézoélectriques, les moyens d'actionnement piézoélectriques étant aptes à déplacer la grille par rapport à ladite zone de canal.
  Une nouvelle structure de transistor aux performances électriques modulables à l'aide d'une grille suspendue et de moyens d'actionnement piézoélectriques de cette grille est mis en oeuvre suivant l'invention.

Un tel dispositif permet d'obtenir une tension de seuil $V_T$ du transistor ajustable.

Un tel dispositif peut avoir un fonctionnement non volatile, et maintenir un mode de fonctionnement du transistor, par exemple un $V_T$ fort ou $V_T$ faible après extinctions des polarisations ou alimentations de l'actionneur. Lorsque le transistor est polarisé à nouveau, il est susceptible d'adopter un mode de fonctionnement dans lequel il a été laissé avant arrêt des polarisations.

Dans un tel dispositif les performances du transistor peuvent être également améliorées par rapport à celles d'un transistor MOS classique. Le courant $I_{ON}$ à l'état passant peut être plus élevé tandis que le courant $I_{OFF}$ à l'état bloqué, peut être plus faible, ce qui permet notamment de réduire la consommation.

Les moyens d'actionnement piézoélectriques comprennent un empilement formé d'au moins une couche de matériau piézoélectrique reposant sur une première électrode de polarisation, une deuxième électrode de polarisation reposant sur la couche de matériau piézoélectrique.

La grille est rattachée audit empilement et suspendue audit empilement.

En fonction du champ électrique extérieur qui lui est appliqué par l'intermédiaire des électrodes, la couche piézoélectrique est susceptible de se déformer. La couche piézoélectrique peut se comprimer ou fléchir de manière à déplacer la grille qui lui est rattachée.

Dans la structure de transistor proposée, l'électrode inférieure de polarisation de la couche de matériau piézoélectrique, peut être en contact avec la grille sur toute la largeur de cette dernière, ce qui peut permettre d'avoir un temps de polarisation de la grille réduit.

La couche de matériau piézoélectrique peut également jouer le rôle de protection de la grille contre des rayonnements extérieurs au dispositif. Ceci peut être utile, notamment pour des applications, par exemple dans l'aéronautique ou le domaine spatial, pour lesquelles le dispositif serait destiné à subir de fortes radiations.

Selon une possibilité, la grille peut être rattachée à, et en contact avec, ladite deuxième électrode. La deuxième électrode et la grille peuvent être mises ainsi au même potentiel électrique.

La grille et la zone diélectrique de grille sont séparées par un espace vide modulable.

La grille peut être située dans une cavité formée entre ledit empilement et ledit substrat. Cela peut permettre de faciliter la déformation de la couche piézoélectrique.

Le dispositif peut également comprendre en outre : au moins un élément isolant de soutien autour dudit empilement, pour maintenir ledit empilement au-dessus du substrat, tout en évitant la formation de court-circuits.

Selon une possibilité de mise en oeuvre, le dispositif peut comporter plusieurs éléments isolants de soutien dudit empilement, dont au moins un élément de soutien contre un flanc dudit empilement et au moins un autre élément de soutien contre un autre flanc dudit empilement. Ledit empilement peut être ainsi soutenu par ses faces latérales.

Selon une possibilité, ledit empilement peut comprendre une ou plusieurs faces latérales ou flancs, libres. Cela peut permettre une déformation améliorée de la couche piézoélectrique.

Le dispositif microélectronique peut comprendre en outre : une pluralité de plots conducteurs dont,

- au moins un premier plot conducteur connecté à la région de source dudit transistor,
- au moins un deuxième plot conducteur connecté à la région de drain dudit transistor,
- au moins un troisième plot conducteur connecté à la grille dudit transistor, le troisième plot étant en contact avec la première électrode ou avec la grille.

Le dispositif microélectronique peut comprendre en outre : au moins un quatrième plot conducteur connecté avec la deuxième électrode.

Selon une variante de mise en oeuvre, ledit premier plot ou ledit deuxième plot, est également connecté à la deuxième électrode. Dans ce cas la deuxième électrode des moyens piézoélectriques et la source ou le drain du transistor peuvent être mis au même potentiel de polarisation.

Les plots conducteurs sont aptes à être connectés à des moyens de polarisation.

Le dispositif microélectronique est apte à adopter au moins une première position dans laquelle la grille est située à une première distance du canal, et à adopter au moins une deuxième position dans laquelle la grille est située à une deuxième distance du canal, différente de la première distance.

Le passage de la première position à la deuxième position est mis en oeuvre à l'aide d'une polarisation adaptée des moyens d'actionnement piézoélectrique. Un effet d'adhésion électrostatique résultant de la différence de potentiel entre la grille et le canal du transistor peut également être utilisé.

La première position de la couche piézoélectrique est une position dans laquelle la couche piézoélectrique est plane, la grille étant à une distance prédéterminée du canal.

La deuxième position, est une position dans laquelle la couche piézoélectrique est fléchie, la grille étant en contact avec la zone de diélectrique de grille. Pour maintenir dans cette deuxième position la grille du transistor, une force d'adhésion également appelée « de collage moléculaire » peut être mise en oeuvre. Une telle adhésion ou un tel collage moléculaire est produit à l'aide de forces attractives par exemple telles que des forces de Van der Waals.

Des moyens d'alimentation aptes à alimenter le transistor et les moyens d'actionnement, peuvent être prévus.

Selon une possibilité de mise en oeuvre, le dispositif est apte à adopter une position donnée parmi lesdites, première position et deuxième position, et apte en outre à maintenir la grille dans ladite position donnée après arrêt ou extinction desdits moyens d'alimentation. La grille peut être maintenue en position après une mise à un potentiel nul de toutes les polarisations du dispositif.

Selon une mise en oeuvre possible du dispositif microélectronique, ce dernier peut être apte, à adopter un état dans lequel, les moyens d'actionnement piézoélectriques sont dans un état de polarisation donné, et dans lequel la grille est maintenue à l'aide des moyens d'actionnement piézoélectriques en contact avec le diélectrique de grille, et à adopter en outre un autre état dans lequel les moyens d'actionnement piézoélectriques ne sont pas polarisés, c'est-à-dire mis à un potentiel nul, et dans lequel la grille est maintenue par collage moléculaire, sous l'effet de forces telles que des forces de Van der Waals, en contact avec le diélectrique de grille. Par moyens d'actionnement « non polarisés » on entend que les électrodes sont mises à un potentiel nul.

Selon une mise en oeuvre possible du dispositif, ce dernier est susceptible d'adopter un état dans lequel les moyens d'actionnement piézoélectriques sont mis dans un état de polarisation, permettant de décoller la grille du diélectrique de grille.

Le dimensionnement des éléments du dispositif est prévu pour permettre à la grille de conserver sa position à l'arrêt ou à l'extinction de toutes les polarisations du dispositif, notamment de celles des moyens d'actionnement piézoélectriques et du transistor.

L'invention concerne également la mise en oeuvre de cellules mémoires non-volatiles, comprenant un dispositif tel que défini précédemment.

La présente invention concerne également un procédé de réalisation d'un dispositif microélectronique doté d'au moins un transistor à grille mobile suspendue et à actionnement piézoélectrique, comprenant les étapes de :

a) formation sur un substrat d'au moins une zone semi-conductrice dans laquelle des zones de source, de drain et de canal d'un transistor sont destinées à être formées, et d'une zone de diélectrique de grille recouvrant ladite zone semi-conductrice,
b) formation d'au moins une couche sacrificielle sur ladite zone de diélectrique de grille,
c) formation d'une grille pour ledit transistor sur ladite couche sacrificielle,
d) formation sur la grille, d'un empilement comprenant au moins une première couche conductrice destinée à former une première électrode, au moins une couche de matériau piézoélectrique reposant sur ladite première couche conductrice, et au moins une deuxième couche conductrice sur ladite couche de matériau piézoélectrique et destinée à former une deuxième électrode, ledit empilement étant destiné à la formation de moyens d'actionnement piézoélectriques de la grille,
e) retrait au moins partiel de ladite couche sacrificielle sur la zone de diélectrique de grille, de manière à détacher la grille du diélectrique de grille.

Selon une possibilité, le procédé peut comprendre après l'étape c), et préalablement à l'étape e), les étapes de :

- formation d'une deuxième couche sacrificielle autour de la grille, sur laquelle ledit empilement est destiné à être réalisé, puis, après l'étape d) :

- gravure dudit empilement et de la deuxième couche sacrificielle, de manière à former au moins un bloc.

Après l'étape de formation dudit bloc et préalablement à l'étape e), le procédé peut comprendre également la formation d'une couche isolante dite « de soutien » autour dudit bloc, contre les faces latérales dudit empilement.

Selon un variante possible, après l'étape d) et préalablement à l'étape e), le procédé peut comprendre la gravure de la couche isolante « de soutien » de manière à conserver au moins un premier élément de soutien contre au moins une première face latérale dudit empilement, et au moins un deuxième élément de soutien contre au moins une deuxième face latérale dudit empilement.

Ledit bloc peut avoir une forme rectangulaire, la gravure de la couche isolante de soutien, étant réalisée de manière à libérer les deux autres faces latérales dudit empilement.

Après l'étape de formation dudit bloc et préalablement à l'étape e), le procédé peut comprendre également : la réalisation d'ouvertures à travers ledit empilement, dont au moins une première ouverture dévoilant la zone de source, au moins une deuxième ouverture dévoilant la zone de drain.

Selon une possibilité, le procédé peut comprendre en outre : la réalisation d'au moins une troisième ouverture dévoilant ladite première couche conductrice ou la grille.

Après l'étape de réalisation des ouvertures et préalablement à l'étape e), le procédé peut comprendre une étape de remplissage desdites ouvertures à l'aide d'au moins un matériau isolant.

Après l'étape de remplissage des ouvertures le procédé peut comprendre également, des étapes de :

- réalisation dans ledit matériau isolant, de trous de dimension critique inférieure à la dimension critique des ouvertures, dont au moins un premier trou dans ladite première ouverture et dévoilant ladite zone de source, au moins un deuxième trou dans ladite deuxième ouverture et dévoilant ladite zone de drain, et au moins un troisième trou dans ladite troisième ouverture et dévoilant ladite première couche conductrice ou la grille,
- remplissage des trous à l'aide d'un matériau conducteur, de manière à former des plots conducteurs, dont au moins un premier plot en contact avec ladite zone de source, au moins un deuxième plot en contact avec ladite zone de drain, et au moins un troisième plot dans ladite troisième ouverture en contact avec ladite première couche conductrice ou la grille.

Le procédé peut comprendre après l'étape de remplissage des ouvertures :

- la réalisation d'au moins un quatrième trou dévoilant la deuxième couche conductrice,
- le remplissage du quatrième trou à l'aide d'au moins un matériau conducteur, de manière à former un plot conducteur en contact avec la deuxième couche conductrice.

Selon une variante, après ladite étape de réalisation des trous, le procédé peut comprendre : une étape d'élargissement de l'embouchure du premier trou ou du deuxième trou, de manière à dévoiler la deuxième couche conductrice, ladite étape de remplissage des trous, conduisant alors à la formation d'au moins un premier plot en contact avec ladite zone de source et la première couche conductrice, ou à la formation d'au moins un deuxième plot en contact avec ladite zone de drain et la deuxième couche conductrice.

Selon autre variante du procédé, ce dernier peut comprendre en outre, après ladite étape de remplissage des trous, des étapes de :

- formation d'un trou supplémentaire, à proximité du premier plot ou du deuxième plot, et dévoilant la deuxième couche conductrice,
- remplissage du trou supplémentaire à l'aide d'un matériau conducteur.

Après l'étape d) et préalablement à l'étape e), le procédé peut comprendre la réalisation d'au moins une ouverture à travers le bloc dévoilant la couche sacrificielle et la deuxième couche sacrificielle.

A l'étape e), la couche sacrificielle et de la deuxième couche sacrificielle peuvent être gravées à travers ladite ouverture.

Selon une possibilité, la couche sacrificielle peut être à base d'un matériau apte à être gravé de manière sélective au moins vis-à-vis du diélectrique de grille et du matériau de grille.

La deuxième couche sacrificielle peut être à base d'un matériau susceptible apte à être gravé de manière sélective au moins vis-à-vis du diélectrique de grille et du matériau de grille.

Selon une possibilité de mise en oeuvre du procédé, la couche sacrificielle, et la deuxième couche sacrificielle peuvent être à base du même matériau.

Le procédé peut comprendre entre l'étape c) et l'étape d), la formation d'espaceurs isolants contre les flancs de la grille.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1, illustre un exemple de dispositif microélectronique selon l'invention, comprenant un transistor à grille suspendue et des moyens d'actionnement piézoélectriques, aptes à déplacer la grille du transistor par rapport au diélectrique de grille et au canal du transistor,
- les figures 2A, 2B, illustrent différentes positions d'un dispositif microélectronique suivant l'invention,
- les figures 3A, 3B, illustrent respectivement des étapes de collement de la grille sur la surface du diélectrique de grille, et de décollement de la grille de la surface du diélectrique de grille, d'un transistor à grille suspendue et actionnement piézoélectrique suivant l'invention,
- les figures 4A, 4B, illustrent un fonctionnement non-volatile d'un dispositif microélectronique suivant l'invention,
- les figures 5A, 5B, illustrent une modulation de la tension de seuil du transistor MOS à grille suspendue suivant l'invention,
- la figure 6, illustre une caractéristique tension de grille-courant de drain d'un transistor suivant l'invention,
- les figures 7A à 7J, illustrent, selon une vue en coupe, des étapes d'un exemple de procédé de réalisation d'un dispositif microélectronique selon l'invention, tandis que les figures 8A à 8E illustrent, selon une vue de dessus, des étapes de cet exemple de procédé,

- les figures 9A à 9D, illustrent, selon une vue en coupe, des étapes d'une variante de procédé de réalisation d'un dispositif microélectronique selon l'invention, tandis que les figures 10A à 10C illustrent, selon une vue de dessus, des étapes de cette variante,

- les figures 11A à 11C, illustrent, selon une vue en coupe, des étapes d'une autre variante de procédé de réalisation d'un dispositif microélectronique selon l'invention, tandis que les figures 12A et 12B illustrent, selon une vue de dessus, des étapes de cette autre variante.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

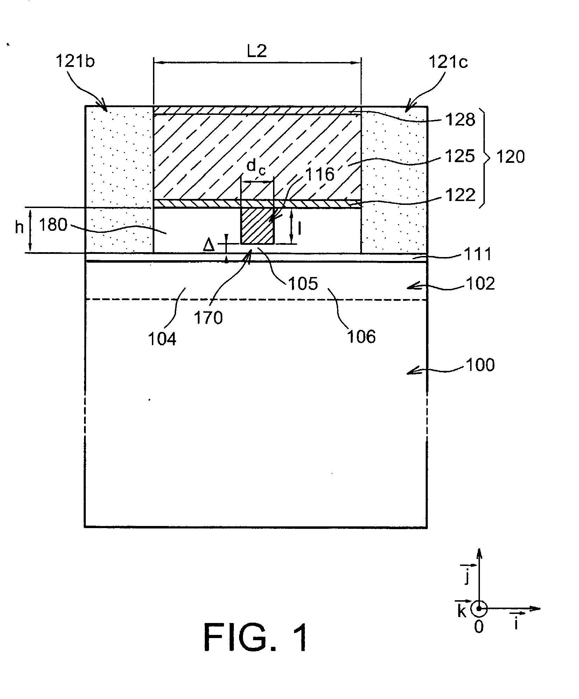

Un exemple de dispositif microélectronique suivant l'invention va à présent être donné en liaison avec la figure 1.

Ce dispositif comprend une structure de transistor reposant sur un substrat 100, qui peut être de type semi-conducteur sur isolant, par exemple un substrat SOI (SOI pour « Silicon On Insulator » ou silicium sur isolant) comportant une fine couche semi-conductrice dans laquelle une zone semi-conductrice 102, par exemple en silicium mono-cristallin, apte à jouer le rôle de zone active, a été réalisée.

Le dispositif suivant l'invention n'est pas limité à un tel substrat et peut être formé par exemple sur un substrat massif ou sur un substrat contraint. La zone semi-conductrice 102 comporte une région de source 104, une région de drain 106, de part et d'autre d'une zone de canal 105 du transistor. La zone semi-conductrice 102 peut avoir une longueur L1 (définie sur la figure 1 dans une direction parallèle au vecteur $\vec{i}$ d'un repère orthogonal $[0;\vec{i};\vec{j};\vec{k}]$). La longueur $L_1$ de la zone semi-conductrice 102 peut être par exemple égale à la distance séparant deux tranchées d'isolation STI (STI pour « shallow trench isolation »).

Une couche 111 de diélectrique de grille, recouvre la zone semi-conductrice 102 et peut être répartie sur toute sa longueur. La couche 111 de diélectrique de grille peut être à base par exemple de $SiO_2$ ou d'un matériau à haute permittivité diélectrique ou « high-k » comme par exemple du $HfO_2$. La couche 111 de diélectrique de grille peut avoir une épaisseur par exemple comprise entre 1 nanomètre et 10 nanomètres, par exemple de l'ordre de 2 nanomètres.

Le transistor comporte une grille 116 suspendue. La grille 116 n'est pas solidaire de, ou n'est pas jointe à, la couche diélectrique 111 de grille. Le dispositif est apte à adopter au moins une position dans laquelle la grille 116 est située à distance de la couche diélectrique 111 de grille, de sorte qu'un espace 170 existe entre la grille 116 et la couche diélectrique de grille 111. La grille 116 et la couche diélectrique de grille 111, peuvent être séparées d'une distance $\Delta$ (définie sur la figure 1 dans une direction parallèle au vecteur $\vec{j}$ d'un repère orthogonal $[0;\vec{i};\vec{j};\vec{k}]$) modulable ou réglable.

La grille 116 peut être formée d'un matériau semi-conducteur, par exemple du silicium polycristallin, ou d'un métal tel que du TiN ou du TaN ou d'un bicouche comportant une couche de métal recouverte par une couche de silicium, par exemple à base de polysilicium. La grille 116 a une dimension critique de (définie sur la figure 1, dans une direction parallèle au vecteur $\vec{i}$) par exemple comprise entre plusieurs nanomètres et plusieurs micromètres, par exemple de l'ordre de 20 nanomètres.

Tout au long de la présente description on entendra par dimension critique, la plus petite dimension d'un motif issu d'une couche ou plusieurs couches minces hormis l'épaisseur de cette ou ces couches. Il est ainsi possible de mettre en oeuvre une grille de dimension critique faible, par exemple au moins inférieure à 100 nanomètres, sans altérer le fonctionnement du dispositif.

La grille 116 peut également avoir une épaisseur e (définie dans une direction parallèle au vecteur $\vec{j}$), par exemple comprise entre 20 nanomètres et plusieurs fois la dimension critique de la grille, par exemple de l'ordre de 50 nanomètres. La grille 116 est suspendue et rattachée par sa face supérieure à des moyens d'actionnement piézoélectriques.

La distance entre la grille 116 et le canal 102 est modulée à l'aide des moyens d'actionnement piézoélectriques. Les moyens d'actionnement piézoélectriques sont aptes à déplacer la grille 116 par rapport au canal 105 du transistor. La grille 116 est susceptible d'adopter plusieurs positions par rapport au canal 105. Par actionnement piézoélectrique, on entend un déplacement de la grille dû à une déformation de la couche piézoélectrique 125 et de ses électrodes 122, 128 associées, par effet piézoélectrique inverse.

Les moyens d'actionnement piézoélectriques 120 comprennent un empilement 120 formé d'une électrode inférieure 122 à laquelle est rattachée la grille 116, une couche de matériau piézoélectrique 125 reposant sur l'électrode inférieure 122, et une électrode supérieure 128 reposant sur la couche de matériau piézoélectrique 125.

L'électrode inférieure 122 et l'électrode supérieure 128 peuvent être sous forme de couches conductrices gravées, et sont prévues pour former des électrodes de polarisation de la couche de matériau piézoélectrique 125.

L'électrode inférieure 122 et l'électrode supérieure 128 peuvent avoir une épaisseur comprise par exemple entre 10 nanomètres et 100 nanomètres, par exemple de l'ordre de 10 nanomètres. La couche de matériau piézoélectrique 125 peut quant à elle avoir une épaisseur comprise par exemple entre 100 nanomètres et 1 micromètre, par exemple de l'ordre de 150 nanomètres.

L'empilement 120 formé par la couche piézoélectrique 125 intercalée entre les deux électrodes 122 et 128 peut avoir une longueur L2 prévue de manière à lui permettre de se déformer, avantageusement supérieure à la dimension critique dc de la grille, par exemple telle que L2 ~ 10*dc.

L'empilement 120 peut être sous forme d'un bloc de motif rectangulaire, ayant une longueur L2, par exemple de l'ordre de 600 nanomètres (définie sur la figure 1 dans une direction parallèle au vecteur $\vec{i}$) et de largeur W2, par exemple de l'ordre de 1000 nanomètres (définie sur la figure 1 dans une direction parallèle au vecteur $\vec{k}$).

Le matériau piézoélectrique de la couche 125 peut être par exemple de l'AlN, du ZnO, du $LiNbO_3$, ou du $LiTaO_3$. Le choix du matériau piézoélectrique peut être prévu notamment de sorte que ce matériau comporte une faible constante diélectrique. La couche 125 peut être à base d'un matériau piézoélectrique de permittivité relative $\varepsilon_R$~ 10 tel que l'AlN, le ZnO, ou $\varepsilon_R$~ 25 tel que du $LiNbO_3$ ou $\varepsilon_R$~ 43 tel que du $LiTaO_3$. En ce qui concerne les propriétés mécaniques du matériau piézoélectrique, le matériau de la couche 125 est choisi suffisamment souple pour pouvoir permettre à la couche 125 de se déformer sous l'effet d'une polarisation, et de déplacer la grille 116 pour la mettre en contact avec le diélectrique 111 de grille, et suffisamment rigide pour que, sous l'effet d'une autre polarisation, la couche piézoélectrique 125 se déforme à nouveau de manière imposer à la grille 116 une force de rappel, lorsque cette dernière est collée à la surface du diélectrique 111.

Le choix des matériaux de chacune des électrodes 122 et 128, peut être également prévu en fonction des propriétés de rigidité que l'on souhaite donner à la structure. Les coefficients piézoélectriques du matériau de la couche 125, et en particulier son coefficient piézoélectrique longitudinal $e_{33}$, sont de préférence les plus élevé possible. Le coefficient piézoélectrique longitudinal $e_{33}$ est défini comme le coefficient représentatif d'une contrainte de la couche 125 dans une direction parallèle au vecteur de polarisation de cette couche 125. D'après l'agencement de la couche 125 et des électrodes 122, 128, le vecteur de polarisation est défini dans une direction (parallèle au vecteur $\vec{j}$ sur la figure 1) orthogonale au plan des électrodes. Le coefficient piézoélectrique longitudinal $e_{33}$ de la couche piézoélectrique 125 peut être par exemple de l'ordre de 1,5 $C/m^2$. Les coefficients piézoélectriques du matériau de la couche 125, et en particulier son coefficient piézoélectrique longitudinal $e_{33}$, est de préférence supérieur à une valeur minimale prédéterminée, correspondant à la valeur pour laquelle la force piézoélectrique ajoutée à la force de rappel exercée par la structure sur la grille du dispositif permet le décollement de la grille dans le cas où la grille est collée contre la surface du diélectrique de grille.

Le dispositif peut être dimensionné à partir des dimensions choisies pour la grille 116, notamment la dimension critique de la grille de et de son épaisseur e. Pour une valeur de dimension critique de de grille donnée, la longueur L2 de l'empilement 120 peut être choisie de préférence de sorte que L2 > de.

Par exemple, lorsque de est de l'ordre de 40 nm, L2 peut être par exemple de l'ordre de 400 nm, soit un rapport L2/dc de l'ordre de 10 ou 12 par exemple.

Le dispositif comporte également un ou plusieurs éléments 121b, 121c, de soutien de l'empilement 120 de l'actionneur piézoélectrique, situés en périphérie de ce dernier. Les éléments de soutien 121b, 121c, peuvent être sous forme de blocs isolants contre lesquels les faces latérales de l'empilement 120 s'appuient, et qui maintiennent cet empilement 120 au-dessus du substrat 100. Les éléments 121b, 121c de soutien sont formés de préférence à base d'au moins un matériau isolant, tel que par exemple du $SiO_2$, ou du $Si_3N_4$, ou d'un empilement de $SiO_2$ et de $Si_3N_4$ afin d'éviter la formation de court-circuits. Le matériau isolant des éléments de soutien 121b, 121c est choisi de préférence de manière à comporter une raideur supérieure à celle de l'empilement 120, afin de préférence, de conserver un maximum de rigidité lors d'une déformation de la couche piézoélectrique 125.

Des plots (non représentés sur la figure 1) sont également prévus pour réaliser les contacts du transistor. Un ou plusieurs plots conducteurs peuvent être également prévus pour réaliser les contacts de l'actionneur piézoélectrique. Des plots conducteurs peuvent être prévus pour connecter ou relier électriquement respectivement, la zone de source 104 à des moyens de polarisation de la source, la zone de drain 106 à des moyens de polarisation du drain 106, la grille 116 et l'électrode inférieure 122 de l'empilement 120 à des moyens de polarisation de la grille et de l'électrode inférieure 122, l'électrode supérieure 128 de l'actionneur à des moyens de polarisation de l'actionneur piézoélectrique.

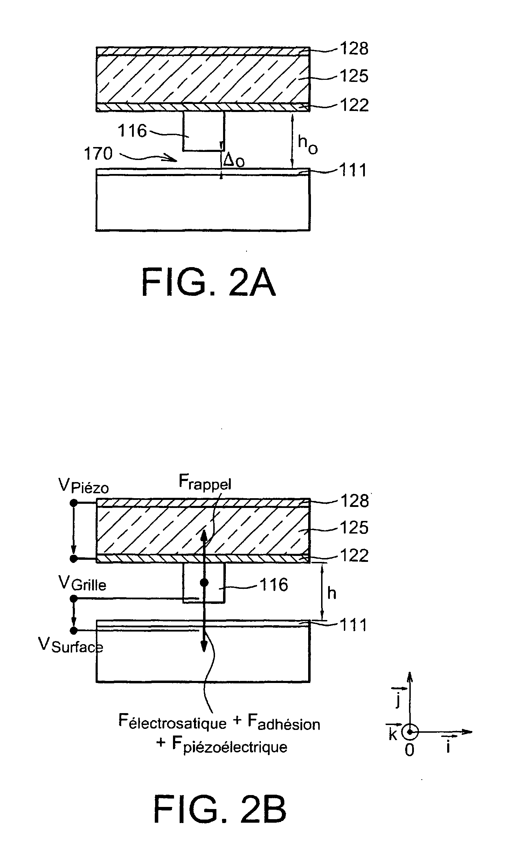

Un exemple de fonctionnement d'un dispositif microélectronique suivant l'invention, va être donné en liaison avec les figures 2A-2B, 3A-3B et 4A-4B.

Le dispositif peut adopter une position dite « de repos » dans laquelle l'empilement 120 est suspendu au-dessus et à une hauteur h0 dite « de repos » de la couche de diélectrique 111 de grille. Dans la position de repos, la grille 116 se trouve à une distance $\Delta 0$ dite « de repos » du diélectrique 111, de sorte qu'un espace vide 170 se trouve entre la grille 116 et la zone de diélectrique 111 de grille. La couche piézoélectrique 125 est plane dans la position de repos. Dans la position de repos, l'alimentation des moyens d'actionnement et du transistor est éteinte, de sorte que toutes les polarisations sont à un potentiel nul (figure 2A).

Lorsqu'ils sont polarisés, les moyens d'actionnement piézoélectriques peuvent actionner la grille 116, et permettre de déplacer cette dernière. Selon la direction du champ électrique extérieur qui lui est appliquée par l'intermédiaire des électrodes 122, 128, cette couche piézoélectrique 125 est apte à se comprimer ou à se détendre, et à déplacer ainsi la grille 116 qui lui est rattachée.

En plus de l'effet piézoélectrique inverse, un effet d'attraction électrostatique résultant de la différence de potentiel entre la grille 116 et le canal 105 du transistor est susceptible d'être mis en oeuvre. Cet effet d'attraction électrostatique se traduit par une force électrostatique tendant à rapprocher la grille 116 du canal 105 du transistor, et qui peut permettre de mettre en contact la grille 116 et le diélectrique 111 de grille.

Une force supplémentaire dite d'adhésion ou également appelée de collage moléculaire peut également être également mise en oeuvre. Un collage moléculaire en particulier de type Van der Waals est susceptible de s'exercer entre la face inférieure de la grille 116 et la surface de diélectrique 111 de grille. La mise en oeuvre de cette force supplémentaire dépend notamment de la planéité de la face inférieure de la grille 116 et de la surface en regard de diélectrique 111 de grille, ainsi que d'un dimensionnement adapté des éléments de la structure. La mise en oeuvre de la force d'adhésion ou de collage moléculaire est décrite par exemple dans les documents suivants : l'article de Asghar Ramezani et al. : « Influence of Van Der Waals Force on the Pull-In Parameters of Cantilever Type Nanoscale Electrostatic Actuators », Microsystem Technologies, 2006, vol. 12, pp. 1153-1161; l'article de W. Merlijn van Spengen et al. : « A Physical Model to Predict Stiction in MEMS », Institute of Physics Publishing, Journal of Micromechanics and Microengineering, 12, (2002), pp.702-713 ; et l'article de Y.-P. ZHAO et al. : « Mechanics of Adhésion in MEMS-a Review », J. Adhesion Sci. TechnoL. Vol. 17, n˚4, pp.519-546, 2003. Par rapport aux autres forces auxquelles la grille est soumise, la force d'adhésion ou de collage moléculaire prend d'autant plus d'importance que la grille est proche du diélectrique de grille.

La mise en oeuvre de la force d'adhésion ou de collage moléculaire, permet de conférer au dispositif un fonctionnement non volatile. Ce dernier est susceptible de se maintenir dans une position donnée lors de l'arrêt de l'alimentation et des polarisations de l'actionneur et du transistor. Lorsque les polarisations sont éteintes, la grille 116 est susceptible d'être maintenue en contact du diélectrique 111 de grille. Lorsque le transistor est polarisé à nouveau, il est susceptible d'adopter le même mode de fonctionnement que celui dans lequel il avait été laissé avant l'arrêt des polarisations.

Sur la figure 2B, le dispositif est mis dans un état de polarisation différent de celui de la position de repos et pour lequel le dispositif adopte une première position dans laquelle la grille 116 n'est pas en contact avec la surface de la couche diélectrique 111 de grille, la grille 116 étant maintenue à une distance $\Delta$ non-nulle de la couche diélectrique 111 de grille. Pour que le dispositif adopte la première position, les moyens piézoélectriques sont placés dans un état de polarisation adapté, un potentiel non-nul étant appliqué aux électrodes. La grille 116 suspendue du transistor peut être alors soumise, à quatre forces, dont une première ou force électrostatique $F_{\text{élecuostatique}}$ due à la différence de potentiel présente entre la grille et la surface du canal du transistor, une deuxième force ou force piézoélectrique $F_{\text{piézoélectrique}}$, engendrée par la différence de potentiel appliquée entre les deux électrodes 122, 128 de polarisation de la couche piézoélectrique, une troisième force ou force de rappel $F_{\text{rappel}}$, correspondant à la raideur du support mécanique de la grille 116, c'est-à-dire à la raideur de l'empilement formé de la couche piézoélectrique 125 et des électrodes 122, 128, et de la couche ou d'éléments isolants de soutien de l'empilement, une quatrième force de collage moléculaire ou force d'adhésion $F_{\text{adhésion}}$, résultante en particulier des forces de Van Der Waals s'exerçant entre la face inférieure de la grille 116 située en regard de la couche de diélectrique 111 de grille et la surface de la couche de diélectrique 111 de grille. Dans la première position, l'état de polarisation des électrodes des moyens d'actionnement, est adapté de sorte que :

$$\left| F_{\text{électrostatique}} \right| + \left| F_{\text{adhésion}} \right| < \left| F_{\text{rappel}} \right| + \left| F_{\text{piézoélectrique}} \right|$$

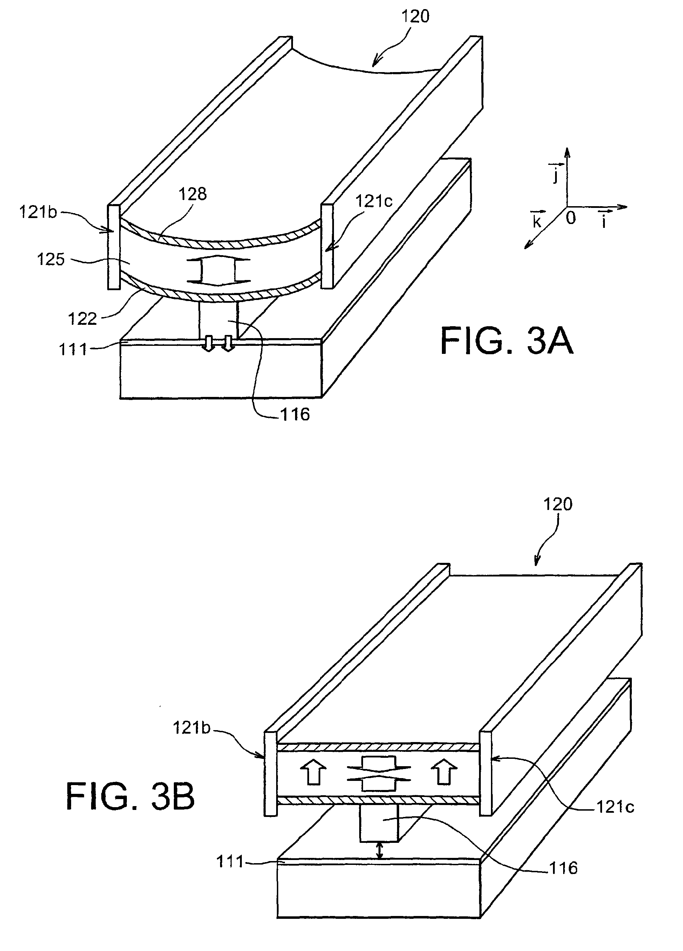

Une polarisation différente des moyens d'actionnement piézoélectriques peut permettre de déplacer cette dernière. La quatrième force peut lors devenir significative lorsque $\Delta$ est rendue faible, par exemple inférieure à 1 nm. Un collage (figure 3A) de la grille 116 sur la couche diélectrique 111 peut être réalisé lorsque la condition suivante est mise en oeuvre :

$$\left| F_{\text{piézoélectrique}} \right| + \left| F_{\text{électrostatique}} \right| + \left| F_{\text{adhésion}} \right| > \left| F_{\text{rappel}} \right|$$

Un dimensionnement prédéterminé des élements du dispositif, et une polarisation adaptée peuvent permettre de réaliser cette condition.

Dans la position de collage, la grille 116 est en contact avec la surface du diélectrique 111 de grille. Lorsque le dispositif est polarisé, la grille 116 du transistor est soumise, en première approximation, aux quatre forces présentées plus haut pour le mécanisme de collage.

Un décollement (figure 3B) de la grille 116 est mis en oeuvre quand la condition suivante est vérifiée :

$$\left| F_{piézoélectrique} \right| + \left| F_{rappel} \right| > \left| F_{électrostatique} \right| + \left| F_{adhésion} \right|$$

Un dimensionnement prédéterminé des éléments du dispositif et une polarisation adaptée peuvent permettre de réaliser cette condition.

On peut souhaiter conserver l'état de fonctionnement du transistor, et ce même après arrêt de toutes les polarisations ou des alimentations, afin de conférer au dispositif un fonctionnement non-volatile.

Pour cela, la grille 116 peut être maintenue, après arrêt des polarisations, dans une position dans laquelle elle se trouvait avant cet arrêt. Lorsque l'on éteint les polarisations, la grille 116 n'est soumise qu'aux forces de rappel de la structure et d'adhésion à la surface du diélectrique 111 de grille. Les forces piézoélectriques et électrostatiques dépendantes des différences de potentiel appliquées, deviennent nulles.

Deux cas de maintien de la position de la grille 116 peuvent par exemple être réalisés.

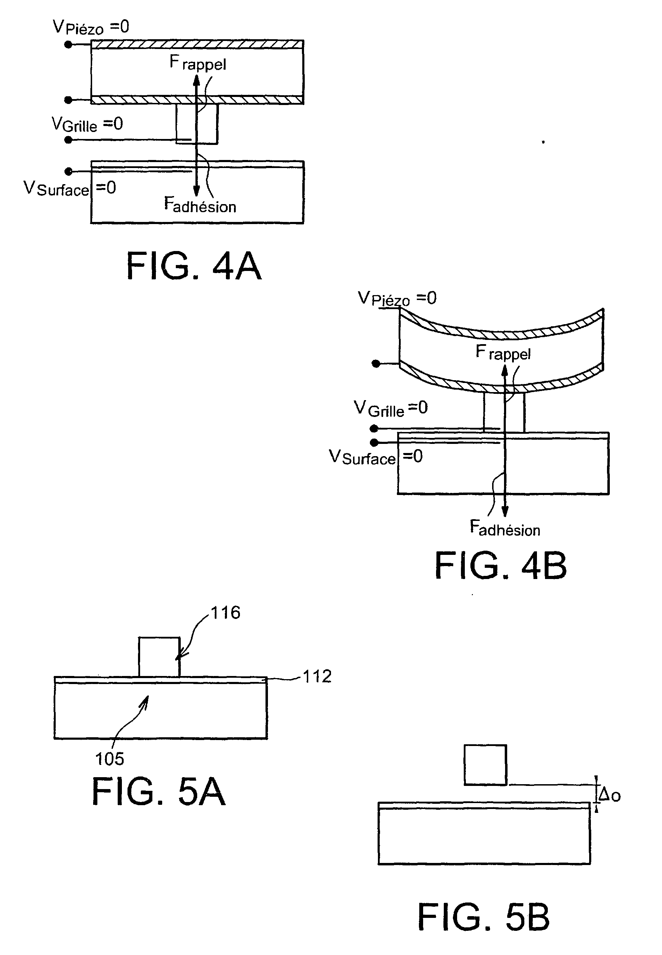

Un premier cas dans lequel, la grille est initialement, décollée ou à distance du diélectrique 111 de grille, et se trouve par exemple dans la première position avant extinction de l'alimentation ou des polarisations. Dans ce cas, après extinction, les forces d'adhésion sont faibles en comparaison des forces de rappel, ce qui permet de maintenir la grille 116 dans la position de repos (figure 4A). Il peut y avoir un déplacement faible de la grille entre la première position, lorsque l'empilement est polarisé mais maintenu à distance de du diélectrique de grille et la position « de repos » pour laquelle les polarisations sont éteintes. Par déplacement faible, on entend un déplacement faible par rapport à la distance Δ0 de repos.

Un deuxième cas dans lequel, la grille 116 est initialement collée contre, ou en contact avec, le diélectrique 111 de grille 116 avant extinction de l'alimentation ou des polarisations. Dans ce cas, après extinction, les forces d'adhésion ne sont pas négligeables devant les forces de rappel. Pour maintenir la grille collée sans polarisation, la condition suivante est mise en oeuvre :

$$\left| F_{adhésion} \right| > \left| F_{rappel} \right|$$

Un dimensionnement prédéterminé des éléments du dispositif, notamment une raideur de l'empilement et de la couche piézoélectrique adaptées ainsi qu'une distance Δ0 de repos choisie peuvent permettre de réaliser cette condition. Les moyens d'actionnement piézoélectriques ainsi que les éléments de soutien de l'empilement ont des dimensions et une composition adaptées, pour réaliser une raideur au bord de l'empilement qui permette de remplir la condition de maintien de la grille dans ledit deuxième cas qui vient d'être donné. Ainsi, lorsque les moyens d'actionnement piézoélectriques ne sont pas polarisés ou alimentés, la grille 116 est susceptible de rester dans sa position collée contre le diélectrique 111, à l'aide de forces d'adhésion qui varient fortement avec la distance séparant la grille 116 du diélectrique 111 de grille, d'avantage que les forces de rappel. Les forces de rappel peuvent être proportionnelles à cette distance tandis que les forces d'adhésion sont inversement proportionnelles à une puissance de cette distance, par exemple inversement proportionnelles au cube de cette distance pour des forces de Van der Waals.

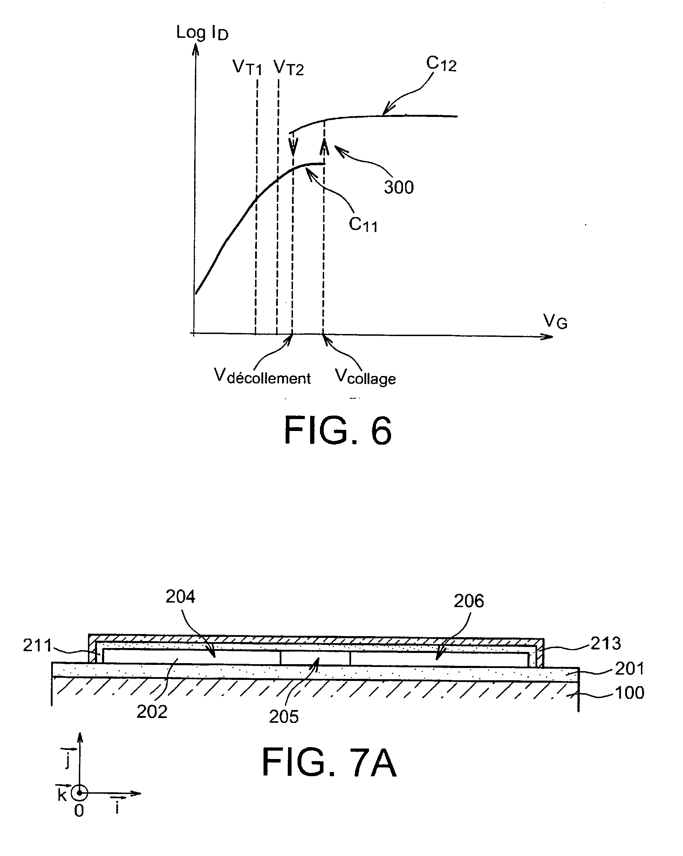

Un exemple de fonctionnement électrique du dispositif microélectronique va à présent être donné en liaison avec les figures 5A-5B et la figure 6.

La tension de seuil $V_T$ du transistor peut être modulée en faisant varier l'épaisseur isolante entre la grille 116 et le canal 105 du transistor.

Sur la figure 5A, la grille 116 du transistor est collée contre ou est en contact avec le diélectrique 111 de grille. L'épaisseur isolante entre la grille 116 et le canal 105 correspond ainsi à l'épaisseur $e_1$ de la couche de diélectrique de grille. Dans cette position, le transistor a une première tension de seuil $V_{T1}$.

Sur la figure 5B, la grille 116 du transistor est située à une distance Δ du diélectrique 111 de grille 116. L'épaisseur isolante entre la grille 116 et le canal 105 correspond à l'épaisseur de la couche de diélectrique de grille ajoutée à une épaisseur Δ d'air entre la grille 116 et le diélectrique 111 de grille. Dans cette position, le transistor a une deuxième tension de seuil $V_{T2}$.

Le transistor peut avoir au moins deux valeurs de tension de seuil distinctes :

- **-** une tension de seuil $V_{T1}$ faible lorsque la grille est en contact avec la surface du diélectrique de grille (grille collée),
- **-** une tension de seuil $V_{T2}$ élevée lorsque la grille n'est pas en contact avec la surface de l'oxyde de grille (grille décollée).

Le transistor du dispositif a une tension de seuil qui peut être modifiée de manière dynamique, et avoir par exemple une première tension de seuil $V_{T1}$ qui peut être par exemple faible lorsque le transistor est à l'état passant et une deuxième tension de seuil $V_{T2}$ par exemple telle que $V_{T2} > V_{T1}$ et qui peut être élevée lorsque le transistor est à l'état bloqué. Les performances électriques du transistor sont ainsi améliorées par rapport à un transistor MOS classique de mêmes dimensions, dans la mesure où par rapport à un tel transistor, le transistor suivant l'invention a un courant $I_{ON}$ plus important circulant dans le canal à l'état passant, et un courant $I_{OFF}$ de canal à l'état bloqué, réduit.

Une courbe caractéristique représentative du courant de drain en fonction du potentiel appliqué sur la grille est donnée sur la figure 6.

Une première portion de la courbe $C_{12}$ correspond à une position dans laquelle la grille est collée contre le diélectrique de grille 111, tandis qu'une autre portion de la courbe $C_{11}$ correspond à une position dans laquelle la grille est décollée ou en position de repos.

Un tel dispositif est susceptible de fonctionner à tension de seuil variable et ainsi de pouvoir avoir une pente sous un seuil inférieure à la limite de 60mV/dec des architectures classiques de transistor MOS à simple ou double grilles.

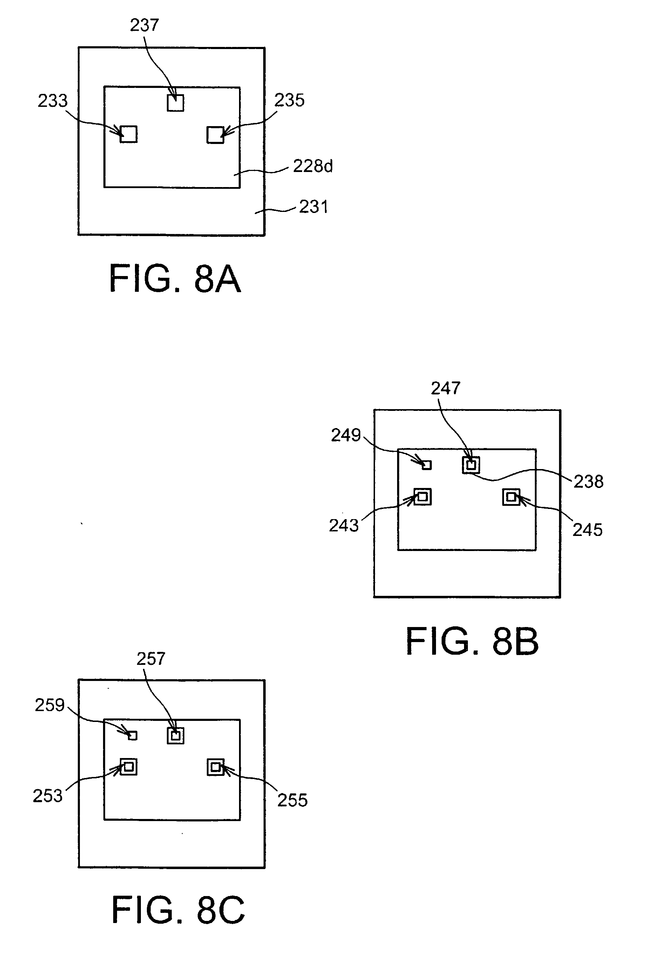

Un exemple de procédé de réalisation d'un dispositif microélectronique tel que décrit précédemment, doté d'un transistor comportant une grille suspendue et surmonté de moyens d'actionnement piézoélectriques, va à présent être donné en liaison avec les figures 7A-7J et 8A-8E (le dispositif en cours de réalisation étant représenté selon une vue en coupe transversale sur les figures 7A-7J et selon une vue de dessus sur les figures 8A-8E).

Dans cet exemple, le matériau de départ est un substrat de type semi-conducteur sur isolant, tel qu'un substrat SOI (SOI pour « Silicon On Insulator » ou Silicium sur isolant). Le procédé suivant l'invention n'est pas limité à un tel substrat et peut être adapté par exemple à une réalisation sur un substrat massif ou sur un substrat contraint. Le substrat de départ peut être formé d'une couche 200 de matériau semi-conducteur, par exemple du silicium monocristallin, surmontée d'une couche 201 de matériau isolant, par exemple d'oxyde de silicium, sur laquelle repose une fine couche de matériau semi-conducteur, par exemple du silicium monocristallin, et prévue pour former une couche active.

Dans la fine couche de matériau semi-conducteur, on défini, par exemple par gravure, au moins une zone semi-conductrice 202.

La zone semi-conductrice 202 peut avoir une longueur L1 (définie sur la figure 7A dans une direction parallèle au plan $[0;\vec{i},\vec{k}]$ d'un repère orthogonal $[0;\vec{i},\vec{j},\vec{k}]$), par exemple de l'ordre de 1 $\mu$m.

On pourra réaliser ensuite dans cette zone semi-conductrice 202, des zones actives de source 204, et de drain 206, de part et d'autre d'une zone de canal 205.

Puis, on recouvre la zone semi-conductrice 202, d'une couche destinée à former une zone de diélectrique 211 de grille surmontée d'une première couche sacrificielle 213. La première couche sacrificielle 213 est destinée à être supprimée ultérieurement afin de désolidariser la future grille du transistor de la couche de diélectrique 211 de grille, et réaliser un espace vide entre cette future grille et la zone de diélectrique 211 de grille.

La zone de diélectrique 211 de grille peut être par exemple à base d'oxyde de silicium et réalisée par une oxydation thermique d'une couche de silicium ou par dépôt d'un matériau diélectrique ayant une constante diélectrique élevée (« high-k » selon la terminologie anglo-saxonne) tel que du $HfO_2$ ou du $Al_2O_3$ ou du $HfSiO_x$. La zone de diélectrique 211 peut avoir une épaisseur comprise par exemple entre 1 nanomètre et 10 nanomètres, par exemple de l'ordre de 2 nanomètres.

La couche sacrificielle 213 est à base d'un matériau apte à être gravé de manière sélective par rapport aux autres matériaux de la structure. La couche sacrificielle 213 est à base d'un matériau apte à être gravé sélectivement par rapport, notamment, au diélectrique 211 et par rapport à la future grille. Le choix du matériau de la couche sacrificielle 213 peut être prévu également en fonction de celui des matériaux de la couche piézoélectrique et d'éléments de soutien de cette couche destinés à être réalisés ultérieurement, de manière à pouvoir être gravé sélectivement par rapport à cette couche piézoélectrique et ces éléments de soutien.

La première couche sacrificielle 213 peut être par exemple à base de Ge ou à base SiGe. Selon un autre exemple, la première couche sacrificielle 213 peut être à base de $SiO_2$ dans le cas où le diélectrique de grille est à base d'un matériau « high-k ». La couche sacrificielle 213 peut avoir une épaisseur comprise par exemple entre plusieurs nanomètres et plusieurs dizaines de nanomètres, par exemple de l'ordre de 4 nanomètres (figure 7A).

On réalise ensuite, à l'aide d'étapes de dépôt, de lithographie et de gravure, une grille 216 à base d'au moins un matériau de grille, métallique par exemple tel que du TiN, ou semi-conducteur par exemple tel que du silicium polycristallin, ou d'un empilement formé d'au moins une couche métallique et d'au moins une couche semi-conductrice.

La grille 216 peut avoir une épaisseur comprise par exemple entre 10 nanomètres et 1 micromètre, par exemple de l'ordre de 50 nanomètres. La grille 216 peut avoir une dimension critique dc comprise par exemple entre plusieurs nanomètres et plusieurs centaines de nanomètres, par exemple de l'ordre de 40 nanomètres. (définie sur la figure 7A dans une direction parallèle au plan $[0;\vec{i},\vec{k}]$ d'un repère orthogonal $[0;\vec{i},\vec{j},\vec{k}]$).

On peut ensuite réaliser des zones d'extension, par exemple par implantation ionique.

Puis on forme des espaceurs isolants 217a, 217b de part et d'autre de la grille 216, à base d'un matériau isolant, par exemple tel que du $SiO_2$ ou du $Si_3N_4$ ou d'un empilement de ces deux matériaux.

On peut effectuer ensuite un dopage de la zone semi-conductrice 202, par exemple par implantation, de manière à réaliser les zones de source 204 et de drain 206.

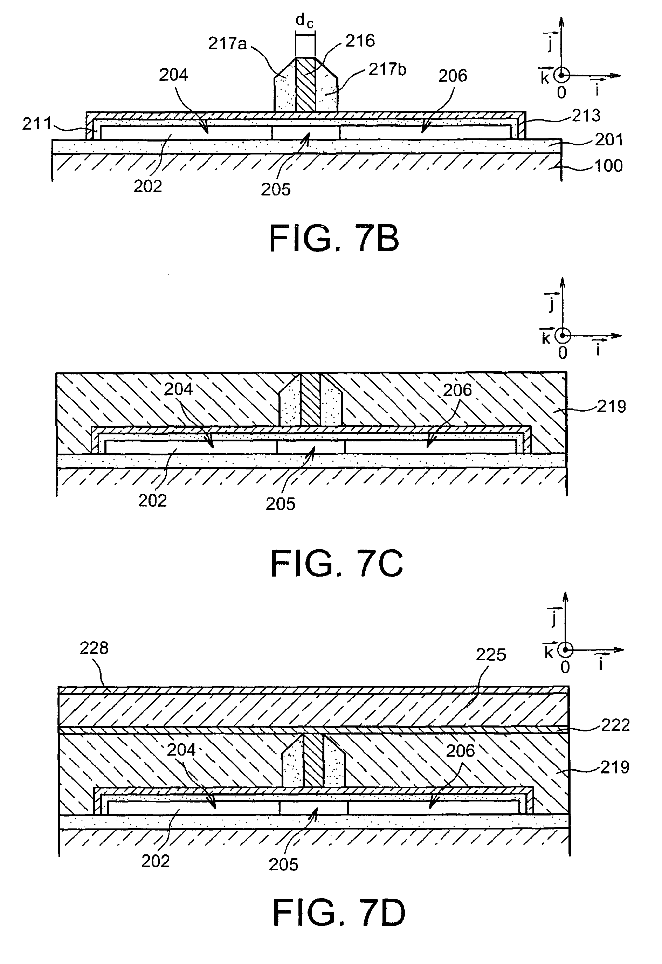

On a ainsi formé une structure semblable à celle d'un transistor MOS en technologie SOI, mais comportant une couche sacrificielle 213 entre la zone de diélectrique 211 de grille et la grille 216 (figure 7B).

La structure est ensuite recouverte d'une deuxième couche sacrificielle 219. Cette deuxième couche sacrificielle 219 peut être réalisée par dépôt, puis retirée dans une zone située au-dessus de la grille 216. Le retrait de la deuxième couche sacrificielle 219 du dessus de la grille peut être effectué par planarisation CMP (CMP pour Chemical Mechanical Planarisation) jusqu'à dévoiler la face supérieure de la grille 216. La deuxième couche sacrificielle 219 peut être à base d'un matériau apte à être gravé de manière sélective par rapport aux autres matériaux de la structure. La deuxième couche sacrificielle 219 peut être à base d'un matériau apte à être gravé sélectivement par rapport, notamment, au diélectrique 211 de grille et par rapport à la future grille. Le choix du matériau de la deuxième couche sacrificielle 219 peut être prévu également en fonction de celui des matériaux d'une couche piézoélectrique et d'éléments de soutien de cette couche piézoélectrique destinés à être réalisées ultérieurement, de manière à pouvoir être gravé sélectivement par rapport à cette couche piézoélectrique et ces éléments de soutien. La deuxième couche sacrificielle 219 peut être par exemple à base de Si. Selon une possibilité, la couche sacrificielle peut être à base d'un même matériau que la première couche sacrificielle, par exemple à base de SiGe ou de Ge. La deuxième couche sacrificielle 219 peut être éventuellement à base de $SiO_2$ notamment dans le cas où le diélectrique de grille est à base d'un matériau « high-k ».

La deuxième couche sacrificielle 219 peut être à base du même matériau que la première couche sacrificielle 213 (figure 7C).

On dépose ensuite un empilement de couches à partir duquel des moyens d'actionnement piézoélectriques sont destinés à être définis.

Cet empilement peut être formé d'une couche 225 à base d'un matériau piézoélectrique comme par exemple de l'AlN, du PZT, du $LiNbO_3$ ou du $LiTaO_3$, du PMN-PT, du $LiNbO_3$, du $LiTaO_3$ intercalée entre deux couches conductrices 222, 228 destinées à jouer le rôle d'électrodes de polarisation de la couche piézoélectrique 225.

Les couches conductrices 222, 228 peuvent être formées d'un matériau métallique, choisi en fonction du matériau employé pour la couche piézoélectrique 225, et qui peut être par exemple du Mo, du Ti ou du Pt. La couche piézoélectrique 225 peut, quant à elle, être réalisée par dépôt d'un matériau piézoélectrique ou par report de ce matériau sur la couche conductrice 222, en utilisant un mécanisme de collage. Un report permet avantageusement de former une couche de matériau piézoélectrique monocristallin.

Le choix du matériau des couches conductrices 222, 228 et du matériau de la couche piézoélectrique 225 est prévu de manière à rendre optimales les propriétés de piézoélectricité, et en particulier la faculté de la couche 225 à se déformer sous l'action d'une tension électrique imposée par les électrodes, de préférence faible ou la plus faible posssible.

Dans un cas par exemple où le matériau piézoélectrique de la couche 225 est de l'AlN, les couches conductrices 222 et 228 peuvent être à base de Mo.

La couche de matériau piézoélectrique peut avoir une épaisseur comprise par exemple entre 100 nanomètres et 1 micromètre, par exemple de l'ordre de 150 nanomètres. Les couches conductrices 222, 228 peuvent quant à elles avoir une épaisseur comprise entre 10 nanomètres et 100 nanomètres, par exemple de l'ordre de 10 nanomètres.

On réalise ensuite au moins un motif, par exemple par photolithographie et gravure de l'empilement de couches 222, 225, 228, et de la deuxième couche sacrificielle 219, de manière à définir un bloc dans lequel, une électrode inférieure 222a, un bloc de matériau piézoélectrique 225a sur l'électrode inférieure, et une électrode supérieure 228a sur le bloc 225a de matériau piézoélectrique sont réalisés. Le bloc formé peut avoir un motif rectangulaire de largeur W et de longueur L (la longueur L étant définie sur la figure 7D dans une direction parallèle au vecteur $\vec{i}$ du repère orthogonal $[0;\vec{i},\vec{j},\vec{k}]$).

Puis, on forme au moins une couche isolante 231 sur la structure par exemple à base de $SiO_2$ ou de $Si_3N_4$, ou un empilement de couches isolantes, par exemple formé d'une fine couche à base de $Si_3N_4$, recouverte par une couche à base de $SiO_2$.

On retire ensuite une portion de cette couche isolante 231 ou de cet empilement, par exemple par gravure, dans une zone située au-dessus de l'électrode 228a supérieure.

Les portions restantes de la couche isolante 231 entourent le transistor ainsi que l'empilement comprenant le bloc 225a piézoélectrique et les électrodes 222a, 228a. Les portions restantes de la couche isolante 231 forment ainsi un soutien ou un élément d'armature, apte à soutenir l'empilement de couches 222a, 225a, 228a de l'actionneur piézoélectrique. Le matériau de la couche isolante 231 peut être choisi de manière à avoir une rigidité supérieure à celle du matériau piézoélectrique 225, de manière à favoriser le déplacement de la grille induit par la déformation de la couche piézoélectrique.

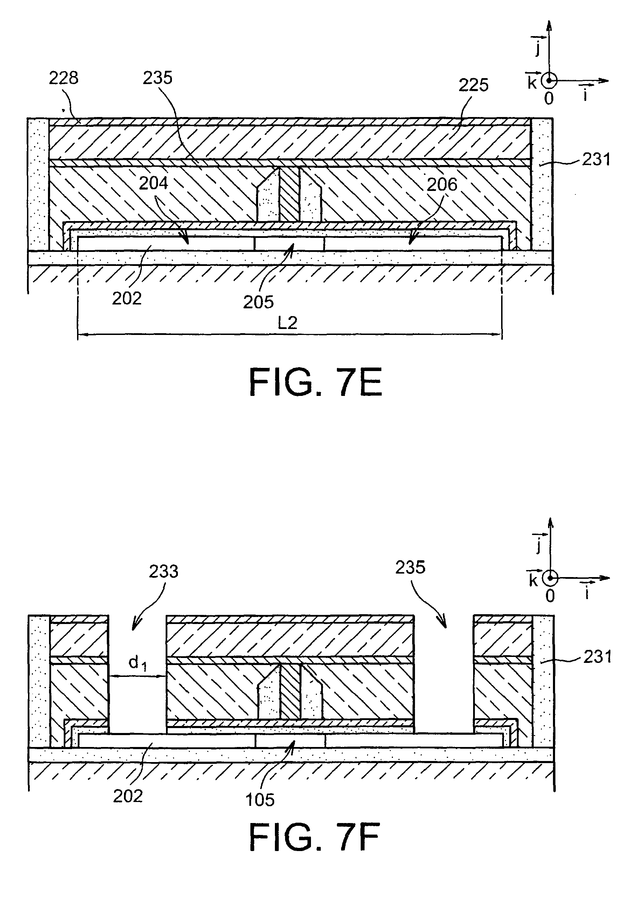

On définit ensuite (figures 7E et 8A), de part et d'autre de la grille du transistor, par exemple par photolithographie et à travers l'empilement de couches 228a, 225a, 222a, des couches sacrificielles 219, 213, et de la zone de diélectrique 211 de grille, des ouvertures 233, 235, dévoilant respectivement la zone de source 204 et la zone de drain 206 définies dans la zone semi-conductrice 202. On réalise également au moins une ouverture 237, à travers les couches 228a, 225a, 222a, de manière à dévoiler la grille 216 ou la première couche conductrice 222.

Les ouvertures 233, 235, 237, peuvent être prévues avec un diamètre ou une dimension critique d1 (défini (e) sur la figure 7F dans une direction parallèle au plan [0;$\vec{i},\vec{k}$]).

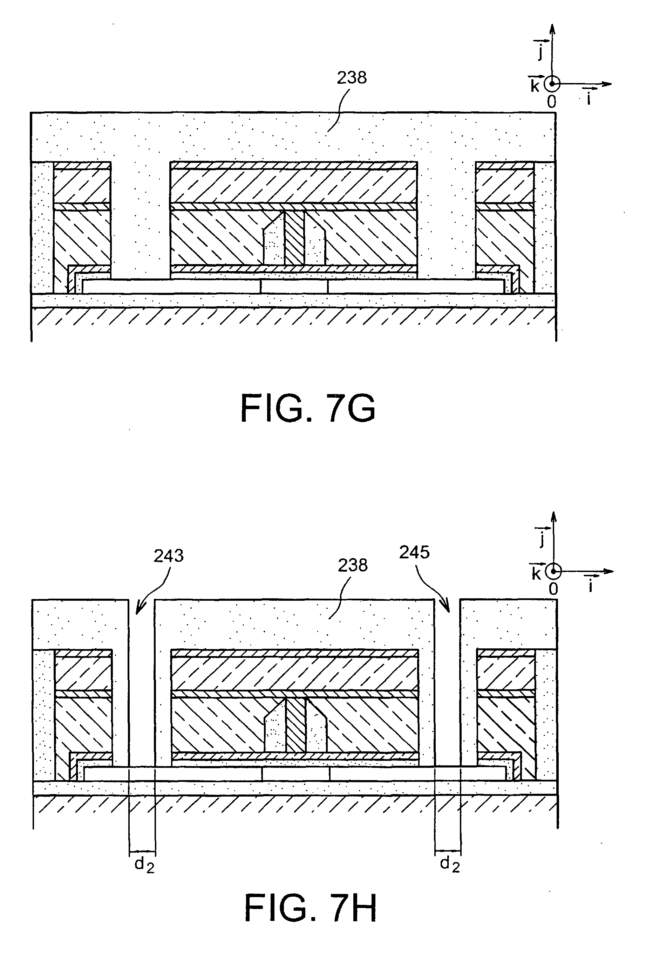

Puis, on effectue un remplissage des ouvertures 233, 235 et 237 à l'aide d'un matériau isolant 238, par exemple du $SiO_2$ (figures 7G). Ensuite, on peut effectuer un polissage mécano-chimique (CMP) de la couche de matériau isolant 238.

Dans les ouvertures 233, 235, et 237 remplies de matériau isolant 238, on réalise respectivement des trous 243, 245 et 247, de diamètre ou de dimension critique d2 (défini(e) sur la figure 7H dans une direction parallèle au plan [0;$\vec{i},\vec{k}$]) inférieur à celui d1 des ouvertures 233, 235 et 237. Les trous 243, 245 et 247 dévoilent respectivement la zone de source 204, la zone de drain 206, et la grille 216 ou la première couche conductrice 222 (figure 7G).

Un trou 249, dévoilant l'électrode supérieure 228a, est également réalisé.

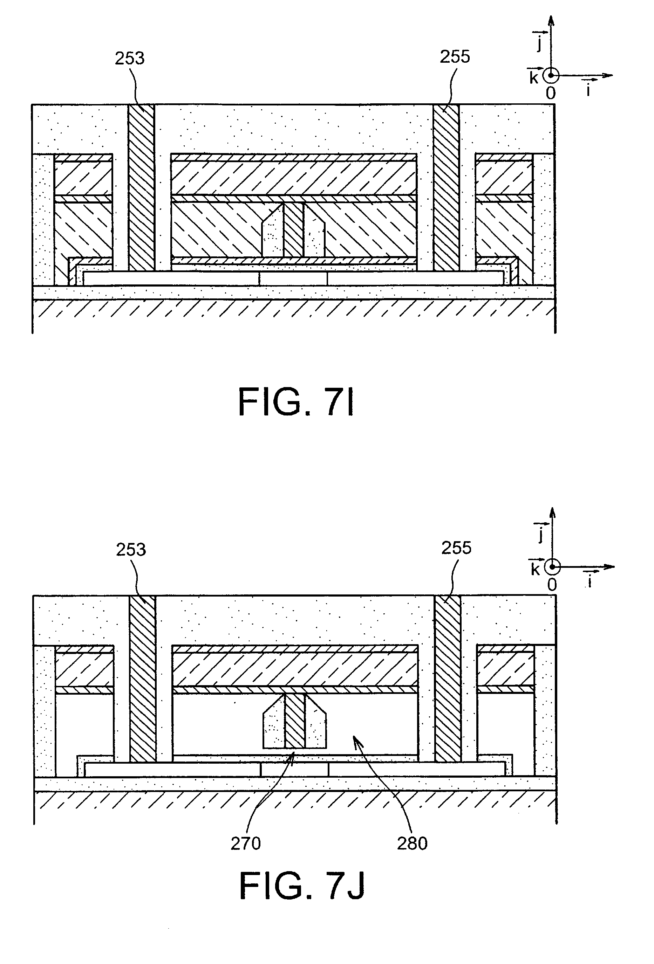

On rempli ensuite les trous 243, 245, et 247, 249 à l'aide d'au moins un matériau conducteur, par exemple un métal tel que du tungstène, de manière à former des plots conducteurs 253, 255 et 257, 259 dans les trous 243, 245 et 247, 249. Les plots conducteurs 253, 255, 257, 259, sont en contact respectivement avec la zone de source 204, la zone de drain 206, avec la grille 216 ou avec l'électrode inférieure 222a, et avec l'électrode supérieure 228a (figures 7I et 8C).

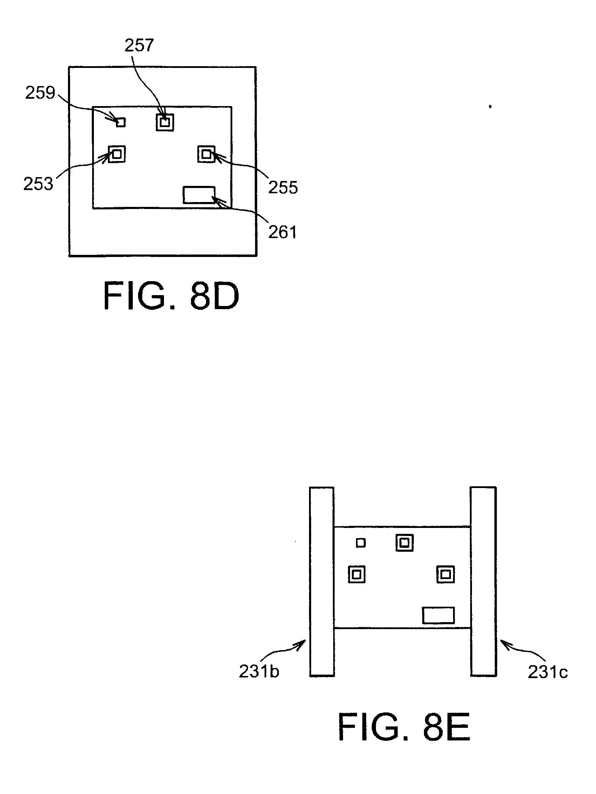

On réalise ensuite au moins une ouverture 261 dans le bloc, traversant l'empilement 220 et les couches sacrificielles 213, 219. L'ouverture 261 peut être réalisée, par exemple à l'aide d'étapes de photolithographie et de gravure (figure 8D).

Ensuite, on effectue un retrait partiel ou total (figure 7J) des couches sacrificielles 213, 219, de manière à désolidariser la grille 216 du diélectrique de grille 211. Le retrait des couches sacrificielles 213, 219, peut être réalisé par exemple par gravure plasma délocalisé, le plasma étant formé dans une chambre donnée puis délocalisé dans une autre chambre dans laquelle est placé le dispositif comportant les couches sacrificielles à retirer.

Le retrait de la première couche sacrificielle 213 est effectué de manière à réaliser un espace 270 entre la grille 216 et la couche diélectrique 211 de grille. Le retrait peut être réalisé par gravure sélective de la première couche vis-à-vis de la grille, du diélectrique de grille. Le retrait peut être par exemple réalisé par gravure sélective d'une première couche sacrificielle semi-conductrice, par exemple en Si, vis-à-vis d'une grille en Ti, d'un diélectrique de grille à base de $SiO_2$. La gravure peut être également sélective vis-à-vis des espaceurs ou/et des éléments de soutien par exemple lorsqu'ils sont à base de $Si_3N_4$.

La deuxième couche sacrificielle 219 peut être également retirée de manière à former un espace autour, ou tout autour de la grille 216. Le retrait peut être réalisé par gravure sélective de la deuxième couche vis-à-vis de la grille, du diélectrique de grille et des éléments de soutien.

Le retrait peut être par exemple réalisé par gravure sélective d'une première couche sacrificielle en SiGe, vis-à-vis d'une grille en Ti, d'un diélectrique de grille à base de $SiO_2$ et d'espaceurs ou/et d'éléments de soutien à base de $Si_3N_4$.

Dans le cas où les deux couches sacrificielles 213 et 219 sont à base d'un même matériau, le retrait des deux couches sacrificielles 213 et 219 peut être réalisé en même temps. Un retrait, éventuellement total, de la deuxième couche sacrificielle 219 peut quant à lui être effectué de manière à réaliser une cavité 280 autour de la grille 216. Après cette étape, de retrait des couches sacrificielles 213, 219, la grille 216 est maintenue ou rattachée par sa face supérieure, à l'électrode inférieure 222a de l'actionneur (figure 7J).

Dans l'exemple de réalisation qui vient d'être donné, l'électrode supérieure 228a reposant sur la couche piézoélectrique 225 n'est connectée ou reliée électriquement à aucun des plots 253, 255, 257, de contact de source, de contact de drain, et de contact de grille 257.

Si besoin, l'électrode supérieure 228a peut être connectée ou reliée électriquement ultérieurement au plot 253 de source, ou au plot 255 de drain, lors d'étapes ultérieures d'une partie de procédé communément appelées « étapes de back-end » au cours desquelles, on réalise une pluralité de niveaux métalliques d'interconnexions des composants du circuit intégré.

Selon une possibilité, la couche de soutien 231, peut être à nouveau gravée de manière à libérer des côtés de l'empilement formé des électrodes 222a, 228a et du bloc piézoélectrique 225a. Dans le cas où un motif de rectangle a été formé dans l'empilement de couches 222a, 225a, 228a, la gravure peut être réalisée de manière à libérer deux côtés, par exemple les deux plus long côtés du rectangle afin de permettre à la couche piézoélectrique 225a de se déformer plus aisément, sous l'action d'une polarisation.

Sur la figure 8E, l'empilement formé des électrodes 222a, 228a et du bloc piézoélectrique 225a est maintenu en suspension au-dessus du substrat 200 par l'intermédiaire de deux éléments isolants ou blocs de soutien 231b, 231c, isolant formés par gravure de la couche isolante 231.

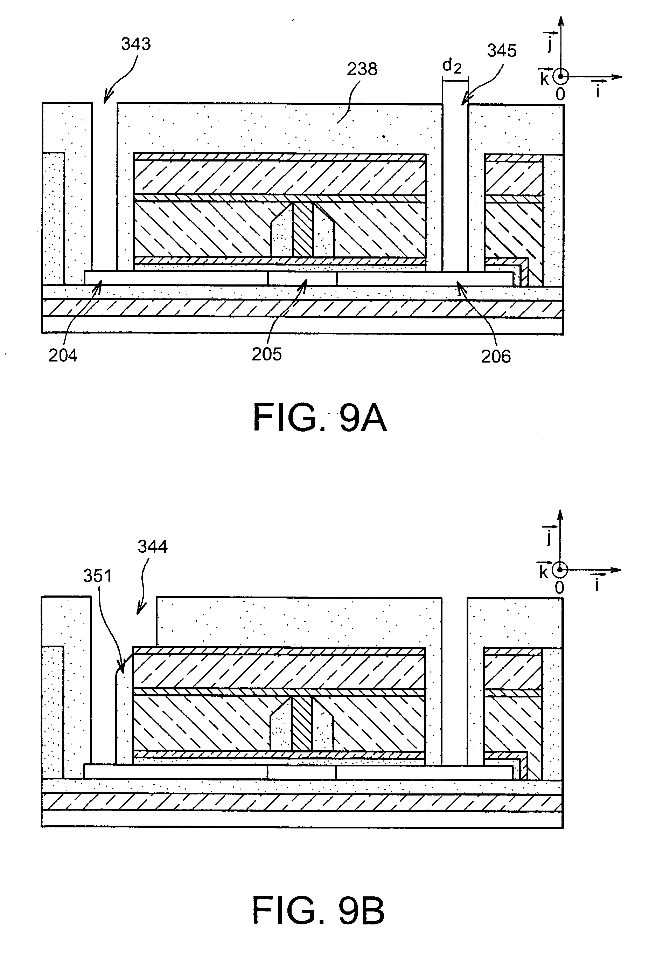

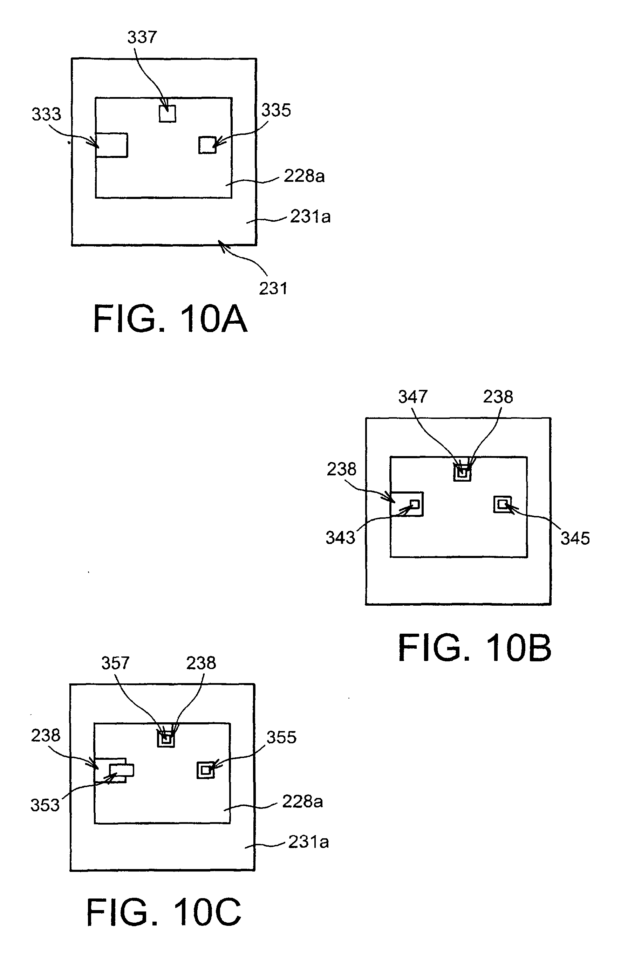

Une variante de l'exemple de procédé qui vient d'être décrit, et en particulier de la réalisation des plots de contact, va à présent être donnée en liaison avec les figures 9A-9D, et 10A-10C (le dispositif en cours de réalisation étant représenté selon une vue en coupe transversale sur les figures 9A-9D et selon une vue de dessus sur les figures 10A-10C).

Pour cette variante, on réalise les mêmes étapes que dans l'exemple de procédé précédemment décrit jusqu'à la réalisation de la couche de soutien 231 à base de matériau isolant (jusqu'à la figure 7E incluse).

On définit ensuite, de part et d'autre du transistor, par exemple par des étapes de photolithographies et de gravures à travers l'empilement de couches 228a, 225a, 222a, des couches sacrificielles 219, 213, et de la zone de diélectrique 211 de grille, des ouvertures 333, 335, dévoilant respectivement la zone de source 204, la zone de drain 206 définies dans la zone semi-conductrice 202, et la grille 216. On forme également au moins une ouverture 337, dévoilant la zone grille 216 ou la première couche conductrice 222a. L'ouverture 333 dévoilant la zone de source 204 peut être prévue avec un diamètre ou une dimension critique supérieure à celui des autres ouvertures 335, 337 (figure 10A).

On effectue ensuite un remplissage des ouvertures 333, 335 et 337 à l'aide d'un matériau isolant 238, par exemple du $SiO_2$.

Dans les ouvertures 333, 335, et 337 remplies de matériau isolant 238, on réalise respectivement des trous 343, 345 et 347, de diamètre inférieur à celui, ou de dimension critique d2 inférieure à celle d1 des ouvertures 333, 335 et 337 (figures 9A et 10B).

On élargi ensuite l'embouchure 344 d'un trou formé en regard d'une zone active, par exemple l'embouchure 344 du trou 343 dévoilant la zone de source 204. L'embouchure du trou 343 est élargie de manière à dévoiler une partie de la face supérieure de l'électrode supérieure 228a de l'actionneur piézoélectrique. On effectue cet élargissement de manière à conserver une zone isolante 351 ou un espaceur isolant 351 entre le trou 343 et l'électrode inférieure 222a de l'actionneur.

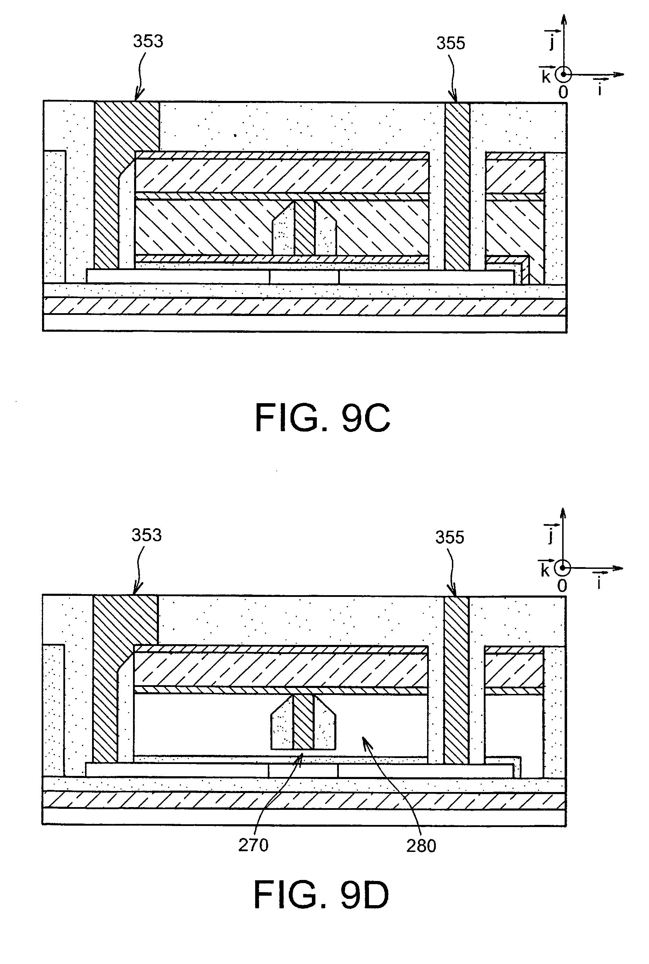

On remplit ensuite les trous 343, 345 et 347, à l'aide d'au moins un matériau conducteur, par exemple un métal tel que du tungstène, de manière à former des plots métalliques 353, 355 et 357 dans les trous 343, 345 et 347. Les plots métalliques 355 et 357, sont en contact respectivement avec la zone de drain, et avec la grille 216. Le plot 353 formé du trou 343 à embouchure élargie et rempli de métal, est quant à lui en contact avec l'électrode supérieure 228a et la zone de source 204 (figures 9C et 10C).

On réalise ensuite au moins une ouverture dévoilant les couches sacrificielles 213, 219. L'ouverture peut être réalisée de manière à traverser les couches sacrificielles 213, 219, ou selon une variante, être réalisée en périphérie de la structure, mais de manière à dévoiler les couches sacrificielles 213, 219.

Ensuite, on effectue, à travers l'ouverture une gravure des couches sacrificielles 213, 219, de manière à retirer ces couches sacrificielles 213, 219, et notamment désolidariser la grille 216 du diélectrique de grille 211. Un espace 270 entre la grille 216 et la couche diélectrique 211 de grille est ainsi formé. Une cavité 280 tout autour de la grille 216 peut être également formée suite au retrait de la deuxième couche sacrificielle 219, par exemple par gravure isotrope sélective (figure 9D).

Selon la variante qui vient d'être donnée, un plot en contact avec la zone de source 204 et la deuxième couche conductrice 222 de l'électrode supérieure 222a a été réalisé. Il est possible, en effectuant un procédé semblable, de former un plot en contact avec la zone de drain 206 et la deuxième couche conductrice 222 de l'électrode supérieure 222a.

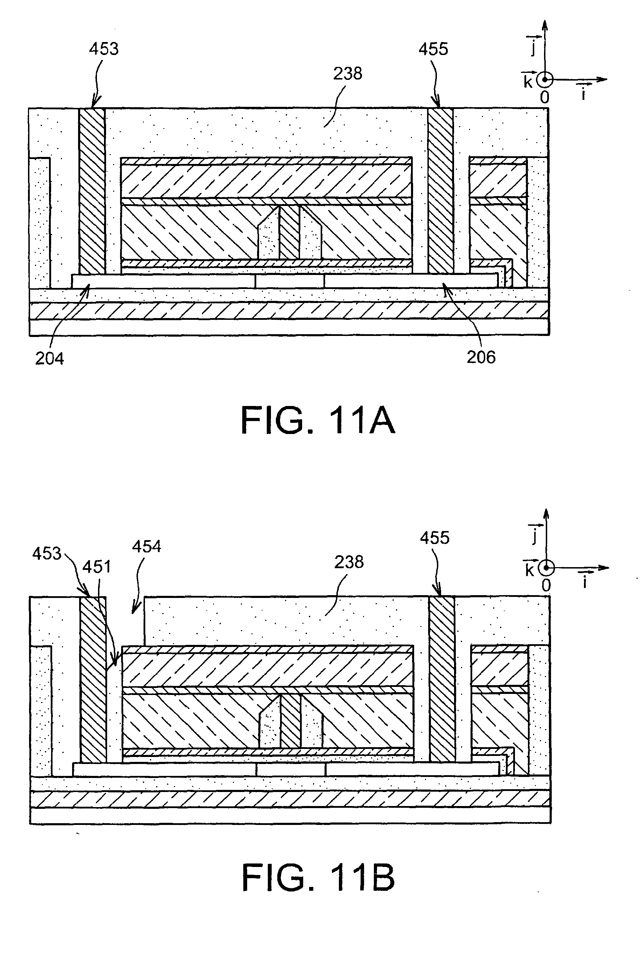

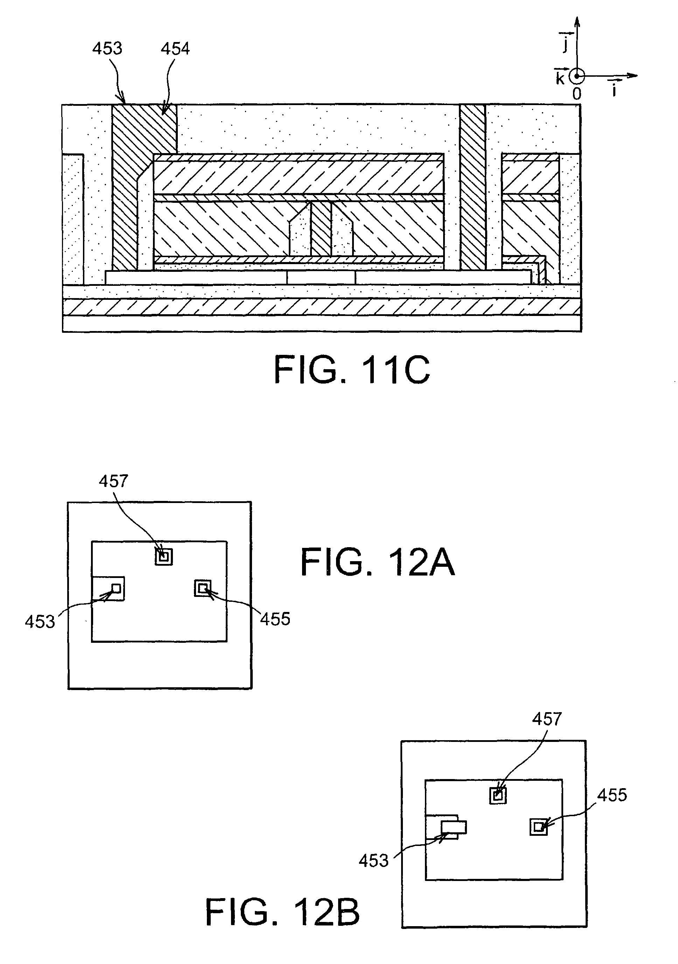

Une autre variante de réalisation des plots de contacts, va à présent être donnée en liaison avec les figures 11A-11C, et 12A-12B (le dispositif en cours de réalisation étant représenté selon une vue en coupe transversale sur les figures 11A-11C et selon une vue de dessus sur les figures 12A-12B).

Pour cette variante, on réalise les mêmes étapes que dans l'exemple de procédé précédemment décrit jusqu'à la réalisation des trous 343, 345 et 347, de diamètre inférieur d2 à celui d1 des ouvertures 333, 335 et 337.

On remplit ensuite les trous 343, 345 et 347, à l'aide d'un métal, par exemple du tungstène, de manière à former des plots conducteurs 453, 455 et 457 dans les trous 343, 345 et 347. Les plots conducteurs 453, 455 et 457, sont en contact respectivement avec la zone de source 204, la zone de drain 206, et avec la grille 216 ou la première électrode 222 (figures 11A et 12A).

A proximité du plot 453 en contact avec la zone de source 204, on réalise ensuite un trou 444 supplémentaire dans le matériau isolant 239, de manière à dévoiler une portion de l'électrode supérieure 228a et des flancs du plot 453. Le trou 444 supplémentaire est réalisé de manière à ce qu'une zone isolante 459 est conservée entre le plot 453 et l'électrode inférieure 222a (figure 11B).

Puis, on effectue un remplissage du trou 444, à l'aide d'un métal, par exemple tel que du tungstène, de manière à former une zone métallique 454 de prolongement du plot 453, en contact avec l'électrode supérieure 228a de l'actionneur piézoélectrique (figures 11C et 12B).

Ensuite, on effectue les étapes telles que décrites précédemment, de réalisation d'au moins une ouverture dans la structure, pour accéder aux couches sacrificielles 213, 219.

Ensuite, on effectue, à travers ladite ouverture une gravure des couches sacrificielles 213, 219, de manière à réaliser un retrait de ces couches sacrificielles 213, 219, et désolidariser la grille 216 du diélectrique de grille 211.

La deuxième couche sacrificielle 219 peut être également retirée de manière à former un espace autour, ou tout autour de la grille 216. Dans le cas où les deux couches sacrificielles 213 et 219 sont à base d'un même matériau, le retrait des deux couches sacrificielles 213 et 219 peut être réalisé en même temps.

Après cette étape, de retrait des couches sacrificielles, la grille 216 est maintenue ou rattachée par sa face supérieure, à l'électrode inférieure 222a de l'actionneur.

Selon la variante qui vient d'être donnée, un plot en contact avec la zone de source 204 et la deuxième couche conductrice 222 de l'électrode supérieure 222a a été réalisé. Il est possible, en effectuant un procédé semblable, de former un plot en contact avec la zone de drain 206 et la deuxième couche conductrice 222 de l'électrode supérieure 222a.

## DOCUMENTS CITES :

[1] : A.M. Ionescu, V. Pott, R. Fritschi, K. Banerjee, M.J. Declercq, Ph. Renaud, C. Hibert, Ph. Fluckiger and G.-A. Racine, : "Modeling and Design of Low Voltage SOI Suspended-Gate MOSFET (SG-MOSFET) with a Metal-Over-Gate Architecture", IEEE International Conference Symposium on Quality Electronic Design (ISQED), San Jose, CA, 2002, pages 18-21.

[2] : H. Kam, D. T. Lee, R. T. Howe, T-J. King, "A new nano-electro-mechanical field effect transistor (NEMFET) design for low-power electronics", IEDM Technical Digest, p.463-466, 2005.

[3] : N. Abelé, K. Séguéni, K. Boucart, F. Casset, L. Buchaillot, P. Ancey, A.M. Ionescu : "Ultra-Low Voltage MEMS Resonator Based on RSG-MOSFET", MEMS, p. 882-885, 2006.

[4] : N. Abelé, A. Villaret, A. Gangadharaiah, C. Gabioud, P. Ancey, A.M. Ionescu : "1T MEMS memory based on suspended gate MOSFET", IEDM 2006.

## Revendications

1. Dispositif microélectronique comprenant au moins un transistor comportant :

   - sur un substrat, une zone semi-conductrice (102, 202) de canal recouverte d'une zone (111, 211) de diélectrique de grille,
   - une grille (116, 216) mobile, suspendue au-dessus du diélectrique de grille, la grille étant située à une distance ajustable de ladite zone de diélectrique de grille,
   - des moyens d'actionnement piézoélectriques, les moyens d'actionnement piézoélectriques étant aptes à déplacer la grille par rapport à ladite zone de canal de manière à faire varier la tension de seuil du transistor, et comprenant un empilement (120, 220) formé d'au moins une couche de matériau piézoélectrique (125, 225) reposant sur une première électrode (122, 222) de polarisation, une deuxième électrode (128, 228) de polarisation reposant sur la couche de matériau piézoélectrique, la grille (116, 216) étant rattachée audit empilement (120, 220) et en contact avec ladite première électrode (122, 222), le dispositif étant apte à adopter au moins une première position dans laquelle la grille (116) est située à une première distance non-nulle du canal, la grille (116, 216) et la zone de diélectrique (111, 211) de grille étant séparées par un espace vide (170, 270), la couche piézoélectrique étant plane, le dispositif étant **caractérisé en ce qu'**il est prévu pour adopter au moins une deuxième position dans laquelle la grille mobile est située à une deuxième distance du canal différente de la première distance, la couche piézoélectrique (125, 225) étant fléchie et la grille (116, 216) en contact avec la zone de diélectrique (111, 211) de grille.

2. Dispositif microélectronique selon la revendication 1, dans lequel là grille est située dans une cavité (180, 280) formée entre ledit empilement (120, 220) et ledit substrat.

3. Dispositif microélectronique selon l'une des revendications 1 ou 2, comprenant en outre au moins un élément isolant (231, 231b, 231c) dit « de soutien », autour dudit empilement (120, 220), et apte à maintenir ledit empilement au-dessus du substrat, ou plusieurs éléments isolants (231b, 231c) de soutien dudit empilement, dont au moins un élément de soutien (231b) contre un flanc dudit empilement et au moins un autre élément de soutien (231c) contre un autre flanc dudit empilement, ledit empilement (120, 220) comprenant une ou plusieurs faces latérales ou flancs, libres.

4.  Dispositif microélectronique selon l'une des revendications 1 à 3, comprenant en outre :

    une pluralité de plots conducteurs dont

        - au moins un premier plot conducteur (253, 353, 453) connecté à la région de source (204) dudit transistor,
        - au moins un deuxième plot conducteur (255, 355, 455) connecté à la région de drain (206) dudit transistor,
        - au moins un troisième plot conducteur (257, 357, 457) connecté à la grille dudit transistor, le troisième plot étant en contact avec la première électrode (222) ou avec la grille (216).

5.  Dispositif microélectronique selon la revendication 4, comprenant en outre : au moins un quatrième plot conducteur (249) connecté avec la deuxième électrode (228).

6.  Dispositif microélectronique selon la revendication 5, dans lequel ledit premier plot (253) ou ledit deuxième plot (255) est également connecté à la deuxième électrode (228).

7.  Dispositif microélectronique selon la revendication 6, comprenant en outre des moyens d'alimentation aptes à alimenter le transistor et les moyens d'actionnement, le dispositif étant apte à adopter une position donnée parmi lesdites première position et deuxième position, et apte en outre à maintenir la grille dans ladite position donnée après arrêt ou extinction desdits moyens d'alimentation.

8.  Dispositif microélectronique selon l'une des revendications 6 ou 7, apte à adopter un état dans lequel, les moyens d'actionnement piézoélectriques sont mis dans un état de polarisation donné, et dans lequel la grille (116, 216) est mise en contact avec le diélectrique (111, 211) de grille à l'aide des moyens d'actionnement piézoélectriques en contact, le dispositif étant apte à adopter un autre état dans lequel les moyens d'actionnement piézoélectriques ne sont pas polarisés, et dans lequel la grille (116, 216) est maintenue par des forces d'adhésion ou de collage moléculaire en contact avec le diélectrique (111, 211) de grille.

9.  Dispositif microélectronique selon la revendication 8, le dispositif étant apte à adopter un état dans lequel les moyens d'actionnement piézoélectriques sont mis dans un état de polarisation donné, permettant de décoller la grille (116, 216) du diélectrique (111, 211) de grille.

10. Cellule de mémoire non volatile comprenant au moins un dispositif microélectronique selon l'une des revendications 1 à 9.

11. Procédé de réalisation d'un dispositif microélectronique doté d'au moins un transistor à grille (216) mobile suspendue et à actionnement piézoélectrique, comprenant l'étape de :

    a) formation sur un substrat (200) d'au moins une zone semi-conductrice dans laquelle des zones de source (204), de drain (206) et de canal (205) d'un transistor sont destinées à être formées, et d'une zone de diélectrique (211) de grille recouvrant ladite zone semi-conductrice (205),
    et **caractérisé par** les étapes de
    b) formation d'au moins une première couche sacrificielle (213) sur ladite zone de diélectrique (211) de grille,
    c) formation d'une grille (216) pour ledit transistor sur ladite couche sacrificielle (213),
    d) formation sur la grille (216) d'un empilement (220) comprenant au moins une première couche conductrice (222) destinée à former une première électrode, au moins une couche de matériau piézoélectrique (225) reposant sur ladite première couche conductrice, et au moins une deuxième couche conductrice (228) sur ladite couche de matériau piézoélectrique et destinée à former une deuxième électrode, ledit empilement (220) étant destiné à la formation de moyens d'actionnement piézoélectriques,
    e) retrait au moins partiel de ladite couche sacrificielle (213) sur la zone de diélectrique (211) de grille, de manière à détacher la grille (216) du diélectrique (211) de grille.

12. Procédé selon la revendication 11, comprenant après l'étape c) et préalablement à l'étape e), les étapes de :

- formation d'une deuxième couche sacrificielle (219) autour de la grille (216), sur laquelle ledit empilement (220) est destiné à être réalisé, puis, après l'étape d) :
- gravure dudit empilement (220) et de la deuxième couche sacrificielle (219), de manière à former au moins un bloc.

**13.** Procédé selon l'une des revendications 11 ou 12, comprenant après l'étape d) et préalablement à l'étape e), la formation d'une couche isolante (231) « de soutien », la gravure de la couche isolante (231) « de soutien » de manière à conserver au moins un premier élément de soutien (231b) contre au moins une première face latérale dudit empilement (220), et au moins un deuxième élément de soutien (231c) contre au moins une deuxième face latérale dudit empilement (220), la gravure de la couche isolante (231) de soutien, étant réalisée de manière à libérer les deux autres faces latérales dudit empilement (220).

**14.** Procédé selon l'une des revendications 11 à 13, comprenant après l'étape d) et préalablement à l'étape e), la réalisation d'au moins une ouverture dévoilant la couche sacrificielle (213) et la deuxième couche sacrificielle (219), l'étape e) comprenant : le retrait, à travers ladite ouverture de la première couche sacrificielle (213) et de la deuxième couche sacrificielle (219).

**15.** Procédé selon l'une des revendications 11 à 14, la première couche sacrificielle étant à base d'un matériau apte à être gravé de manière sélective au moins vis-à-vis de la grille et du diélectrique de grille et/ou la deuxième couche sacrificielle étant à base d'un matériau susceptible apte à être gravé de manière sélective au moins vis-à-vis de la grille et du diélectrique de grille et/ou la première couche sacrificielle (213), et la deuxième couche sacrificielle (219) étant à base du même matériau.

**Claims**

**1.** A Microelectronic device, including at least one transistor comprising:

- on a substrate, a semiconductor channel zone (102, 202) covered with a gate dielectric zone (111, 211),
- a mobile gate, suspended above the gate dielectric zone, said gate being located at an adjustable distance from said gate dielectric zone,
- piezoelectric actuation means, said piezoelectric actuation means being capable of moving the gate with respect to said channel so as to make the threshold voltage of the transistor vary, and comprising a stack formed by at least one layer of piezoelectric material (125, 225) resting on a first biasing electrode (122, 222), a second biasing electrode (128, 228) resting on the piezoelectric material layer, said gate being attached to said stack and in contact with said first electrode, the device being capable of adopting at least one first position wherein the gate (116) is located at a non nil first distance from the channel, the gate (116, 216) and the dielectric gate zone (111, 211) being separated by an empty space (170, 270), said piezoelectric layer being planar, the device being **characterized in that** it is capable of adopting at least a second position wherein the gate (116) is located at a second distance from the channel different from said first distance, the piezoelectric layer being bent, and the gate being in contact with the gate dielectric zone (111, 211).

**2.** Microelectronic device according to claim 1, the gate being located in a cavity (180, 280) formed between said stack (120, 220) and said substrate.

**3.** Microelectronic device according to claim 2, further comprising at least one insulating support element (231, 231b, 231c), around said stack (120, 220), and capable of holding said stack above the substrate, and a plurality of insulating elements (231b, 231c) for supporting said stack, including at least one support element (231b) against a flank of said stack and at least one other support element (231c) against another flank of said stack, said stack (120, 220) including one or more free lateral faces or flanks.

**4.** Microelectronic device according to any of claims 1 to 3, further comprising : a plurality of conductive pads including:

- at least one first conductive pad (253, 353, 453) connected to the source (204) region of said transistor,
- at least one second conductive pad (255, 355, 455) connected to the drain (206) region of said transistor,
- at least one third conductive pad (257, 357, 457) connected to the gate of said transistor, which third pad is in contact with the first electrode (222) or the gate (216).

5. Microelectronic device according to claim 4, further comprising: at least one fourth conductive pad (249) connected to the second electrode (228).

6. Microelectronic device according to claim 5, said first pad (253) or said second pad (255) being also connected to the second electrode (228).

7. Microelectronic device according to claim 6, including power supply means capable of powering the transistor and the actuation means, which device is capable of adopting a given position among said first and second positions, and is also capable of holding the gate in said given position after said power supply means have been stopped or cut off.

8. Microelectronic device according to claim 6 or 7, being capable of adopting a state wherein the piezoelectric actuation means are set in a given biasing state, and wherein the gate (116, 216) is held by the piezoelectric actuation means in contact with the gate dielectric (111, 211), and also of adopting another state wherein the piezoelectric actuation means are not biased, and wherein the gate is held, by forces of adhesion or molecular bonding, in contact with the gate dielectric.

9. Microelectronic device according to claim 8, being capable of adopting a state wherein the piezoelectric actuation means are set in a given biasing state making it possible to separate the gate (116, 216) from the gate dielectric (111, 211).

10. Non-volatile storage cell, including at least one Microelectronic device according to any of claims 1 to 9.

11. Method for producing a microelectronic device equipped with at least one suspended mobile gate (216) transistor with piezoelectric actuation, including:

    a) forming, on a substrate, at least one semiconductor zone wherein source, drain and channel zones of a transistor are intended to be formed, and a gate dielectric zone covering said semiconductor zone, and **characterized by** the steps of
    b) forming at least one sacrificial (213) layer on said gate dielectric zone (211),
    c) forming a gate (216) for said transistor on said sacrificial layer,
    d) forming, on the gate, a stack (220) including at least one first conductive (222) layer intended to form a first electrode, with at least one piezoelectric material layer (225) resting on said first conductive layer, and at least one second conductive layer (228) on said piezoelectric material layer and intended to form a second electrode, wherein said stack is intended for the formation of means for piezoelectric actuation of the gate,
    e) at least partially removing said sacrificial layer (213) on the gate dielectric zone (211), so as to detach the gate from the gate dielectric (211).

12. Method according to claim 11, comprising, after step c), and prior to step e), the steps of:

    - forming a second sacrificial layer (219) around the gate (216), on which said stack (220) is intended to be produced, then, after step d):
    - etching said stack (220) and the second sacrificial layer (219), so as to form at least one block.

13. Method according to claim 11 or 12, comprising, after step d) and prior to step e), the formation of a so-called insulating "support" layer around said block, etching said support layer so as to keep at least a first support element (231b) against a first lateral side of said stack (220), and at least a second support element (231c) against a second lateral side of said stack (220), said etching of said insulating layer being made so as to liberate two other sides of said stack.

14. Method according to one of claims 11 to 13, comprising, after the step of forming said block and prior to step e), the fabrication of at least one opening revealing said sacrificial layer (213) and the second sacrificial layer (219), step e) comprising removing, through said opening of said first sacrificial layer (213) and second sacrificial layer (219).

15. Method according to one of claims 11 to 14, wherein the first sacrificial layer is based on a material capable of being etched selectively at least with respect to the gate and the gate dielectric and/or the second sacrificial layer being based on a material capable of being etched selectively at least with respect to the gate and the gate dielectric and/or the first sacrificial layer, and the second sacrificial layer being based on same material.

**Patentansprüche**

1. Mikroelektronische Vorrichtung, die wenigstens einen Transistor aufweist, der umfasst:

   - einen halbleitenden Kanalbereich (102, 202), der mit einem Gatedielektrikumbereich (111, 211) überzogen ist,
   - ein bewegliches frei hängendes Gate (116, 216) über dem Gatedielektrikum, wobei das Gate sich in einem einstellbaren Abstand von dem besagten Gatedielektrikumbereich befindet,
   - piezoelektrische Aktivierungseinrichtungen, wobei die piezoelektrischen Aktivierungseinrichtungen angepasst sind, das Gate in Bezug auf den Kanalbereich in einer Weise zu verschieben, dass die Schwellwertspannung des Tranistors geändert wird, und einen Stapel (120, 220) umfassen, der aus wenigstens einer Schicht aus piezoelektrischem Material (125, 225), das auf einer ersten Polarisationselektrode (122, 222) ruht, einer zweiten Polarisationselektrode (128, 228), die auf der piezoelektrischen Materialschicht ruht, gebildet ist, wobei das Gate (116, 216) an den genannten Stapel (120, 220) angeschlossen und in Kontakt mit der ersten Elektrode (122, 222) ist, wobei die Vorrichtung angepasst ist, wenigstens eine erste Position einzunehmen, in welcher das Gate (116) sich in einem ersten Abstand ungleich null von dem Kanal befindet, wobei das Gate (116, 216) und der Gatedielektrikumbereich (111, 211) durch einen Leerraum (170, 270) getrennt sind, wobei die piezoelektrische Schicht eben ist, wobei die Vorrichtung **dadurch gekennzeichnet ist, dass** sie vorgesehen ist, um wenigstens eine zweite Position einzunehmen, in welcher das bewegliche Gate sich in einem zweiten Abstand von dem Kanal befindet, der sich von dem ersten Abstand unterscheidet, wobei die piezoelektrische Schicht (125, 225) sich biegt und das Gate (116, 216) in Kontakt mit dem Gatedielektrikumbereich (111, 211) ist.

2. Mikroelektronische Vorrichtung nach Anspruch 1, in der das Gate sich in einem Hohlraum (180, 280) befindet, der zwischen dem Stapel (120, 220) und dem Substrat ausgebildet ist.

3. Mikroelektronische Vorrichtung nach einem der Ansprüche 1 oder 2, die ferner aufweist: wenigstens ein sogenanntes "Verstärkungs"-Isolierelement (231, 231b, 231c) um den Stapel (120, 220) herum, das angnepasst ist, den Stapel über dem Substrat zu halten, oder mehrere Verstärkungsisolierelemente (231b, 231c) des Stapels, von denen wenigstens ein Verstärkungselement (231b) gegen eine Seite des Stapels und wenigstens ein anderes Verstärkungselement (231c) gegen eine andere Seite des Stapels liegt, wobei der Stapel (120, 220) ein oder mehrere freie seitliche Flächen oder Seiten umfasst.

4. Mikroelektronische Vorrichtung nach einem der Ansprüche 1 bis 3, die ferner aufweist:

   mehrere Leiterkontakte, von denen

   - wenigstens ein erster Leiterkontakt (253, 353, 453) mit dem Source-Bereich (204) des Transistors verbunden ist;
   - wenigstens ein zweiter Leiterkontakt (255, 355, 455) mit dem Drain-Bereich (206) des Transistors verbunden ist;
   - wenigstens ein dritter Leiterkontakt (257, 357, 457) mit dem Gate des Transistors verbunden ist, wobei der dritte Kontakt mit der ersten Elektrode (222) oder mit dem Gate (216) in Kontakt ist.

5. Mikroelektronische Vorrichtung nach Anspruch 4, die ferner aufweist: wenigstens einen vierten Leiterkontakt (249), der mit der zweiten Elektrode (228) verbunden ist.

6. Mikroelektronische Vorrichtung nach Anspruch 5, in welcher der erste Kontakt (253) oder der zweite Kontakt (255) ebenfalls mit der zweiten Elektrode (228) verbunden sind.

7. Mikroelektronische Vorrichtung nach Anspruch 6, die ferner aufweist: Versorgungsmittel, die angepasst sind, den Transistor und die Aktivierungseinrichtungen zu versorgen, wobei die Vorrichtung angepasst ist, eine gegebene Position aus der ersten und der zweiten Position einzunehmen, und angepasst ist, ferner das Gate nach dem Stopp oder Erlöschen der Versorgungsmittel in der gegebenen Position zu halten.

8. Mikroelektronische Vorrichtung nach einem der Ansprüche 6 oder 7, die angepasst ist, einen Zustand anzunehmen, in dem die piezoelektrischen Aktivierungseinrichtungen in einen gegebenen Polarisationszustand gebracht sind, und in dem das Gate (116, 216) mit Hilfe der in Verbindung stehenden piezoelektrischen Aktivierungseinrichtungen in Kontakt mit dem Gatedielektrikum (111, 211) gebracht ist, wobei die Vorrichtung angepasst ist, einen anderen Zustand anzunehmen, in dem die piezoelektrischen Aktivierungseinrichtungen nicht polarisiert sind, und in dem das Gate (116, 216) von Haftkräften oder molekularen Anziehungskräften in Kontakt mit dem Dielektrikum (111, 211) gehalten wird.

9. Mikroelektronische Vorrichtung nach Anspruch 8, wobei die Vorrichtung angepasst ist, einen Zustand anzunehmen, in dem die piezoelektrischen Aktivierungseinrichtungen in einen gegebenen Polarisationszustand gebracht werden, der es erlaubt, das Gate (116, 216) von dem Gatedielektrikum (111, 211) zu lösen.

10. Nichtflüchtige Speicherzelle, die wenigstens eine mikroelektronische Vorrichtung nach einem der Ansprüche 1 bis 9 aufweist.

11. Verfahren zur Realisierung einer mikroelektronischen Vorrichtung, die mit wenigstens einem Transistor mit einem beweglichen frei hängenden Gate (216) und zur piezoelektrischer Aktivierung versehen ist, das aufweist:

    a) Bilden wenigstens eines halbleitenden Bereichs auf einem Substrat (200), in dem der Source- (204), Drain (206) und Kanal- (205) Bereiche eines Transistors gebildet werden sollen, und eines Gatedielektrikumbereichs (211), der den halbleitenden Bereich (205) bedeckt, und
    **gekennzeichnet durch** die folgenden Schritte:
    b) Bilden wenigstens einer ersten Opferschicht (213) auf dem Gatedielektrikumbereich (221),
    c) Bilden eines Gate (216) für den Transistor auf der Opferschicht (213),
    d) Bilden eines Stapels (220) auf dem Gate (216), der aufweist: wenigstens eine erste leitende Schicht (222), die dafür bestimmt ist, eine erste Elektrode zu bilden, wenigstens eine Schicht aus piezoelektrischem Material (225), das auf der ersten leitenden Schicht ruht, und wenigstens eine zweite leitende Schicht (228) auf der piezoelektrischen Materialschicht, die dafür bestimmt ist, eine zweite Elektrode zu bilden, wobei der Stapel (220) zum Bilden der piezoelektrischen Aktivierungseinrichtungen bestimmt ist,
    e) zumindest teilweises Abnehmen der Opferschicht (213) auf dem Gatedielektrikumbereich (211) derart, dass das Gate (216) von dem Gatedielektrikum (211) gelöst wird.

12. Verfahren nach Anspruch 11, das nach dem Schritt c) und vor dem Schritt e) die folgenden Schritte aufweist:

    - Bilden einer zweiten Opferschicht (219) um das Gate (216) herum, auf welcher der Stapel (220) realisiert werden soll, dann, nach dem Schritt d):
    - Ätzen des Stapels (220) und der zweiten Opferschicht (219) derart, dass wenigstens ein Block gebildet wird.

13. Verfahren nach einem der Ansprüche 11 oder 12, das nach dem Schritt d) und vor dem Schritt e) aufweist: Bilden einer "Verstärk-ungs"-Isolierschicht (231), Ätzen der "Verstärkungs"-Isolierschicht (231) derart, dass wenigstens ein erstes Verstärkungselement (231b) gegen wenigstens eine erste seitliche Fläche des Stapels (220) und wenigstens ein zweites Verstärkungselement (231c) gegen wenigstens eine zweite seitliche Fläche des Stapels (220) erhalten bleiben, wobei das Ätzen der Verstärkungsisolierschicht (231) derart realisiert wird, dass die zwei anderen seitlichen Flächen des Stapels (220) freigelegt werden.

14. Verfahren nach einem der Ansprüche 11 bis 13, das nach dem Schritt d) und vor dem Schritt e) die Realisierung wenigstens einer Öffnung aufweist, welche die Opferschicht (213) und die zweite Opferschicht (219) enthüllt, wobei der Schritt e) aufweist: Abnehmen der ersten Opferschicht (213) und der zweiten Opferschicht (219) durch die Öffnung.

15. Verfahren nach einem der Ansprüche 11 bis 14, wobei die erste Opferschicht auf einem Material basiert, das angepasst ist, wenigstens gegenüber dem Gate und dem Gatedielektrikum in selektiver Weise geätzt zu werden, und/oder wobei die zweite Opferschicht auf einem empfindlichen Material basiert, das angepasst ist, wenigstens gegenüber dem Gate und dem Gatedielektrikum selektiv geätzt zu werden, und/oder wobei die erste Opferschicht (213) und die zweite Opferschicht (219) auf dem gleichen Material basieren.

FIG. 1

# FIG. 2A

# FIG. 2B

FIG. 3A

FIG. 3B

$V_{Piézo} = 0$

$F_{rappel}$

$V_{Grille} = 0$

$V_{Surface} = 0$

$F_{adhésion}$

## FIG. 4A

$V_{Piézo} = 0$

$F_{rappel}$

$V_{Grille} = 0$

$V_{Surface} = 0$

$F_{adhésion}$

## FIG. 4B

116

112

105

## FIG. 5A

$\Delta_o$

## FIG. 5B

FIG. 6

FIG. 7A

FIG. 7B

FIG. 7C

FIG. 7D

FIG. 7E

FIG. 7F

FIG. 7G

FIG. 7H

253    255

$\vec{j}$

$\vec{k}$ ⊙
0    $\vec{i}$

## FIG. 7I

253    255

$\vec{j}$

$\vec{k}$ ⊙
0    $\vec{i}$

270    280

## FIG. 7J

237

233          235

228d

231

# FIG. 8A

247

249          238

243          245

# FIG. 8B

257

259

253          255

# FIG. 8C

FIG. 8D

FIG. 8E

FIG. 9A

FIG. 9B

353 355

# FIG. 9C

353 355

270 280

# FIG. 9D

FIG. 10A

FIG. 10B

FIG. 10C

FIG. 11A

FIG. 11B

453  454

$\vec{j}$

$\vec{k}$  0  $\vec{i}$

# FIG. 11C

457

# FIG. 12A

453  455

457

455

453

# FIG. 12B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060284239 A1

**Littérature non-brevet citée dans la description**

- **ASGHAR RAMEZANI et al.** Influence of Van Der Waals Force on the Pull-In Parameters of Cantilever Type Nanoscale Electrostatic Actuators. *Microsystem Technologies,* 2006, vol. 12, 1153-1161
- A Physical Model to Predict Stiction in MEMS. **W. MERLIJN VAN SPENGEN et al.** Journal of Micromechanics and Microengineering. Institute of Physics Publishing, 2002, vol. 12, 702-713
- **Y.-P. ZHAO et al.** Mechanics of Adhésion in MEMS-a Review. *J. Adhesion Sci. TechnoL.,* vol. 17 (4), 519-546
- **A.M. IONESCU ; V. POTT ; R. FRITSCHI ; K. BANERJEE ; M.J. DECLERCQ ; PH. RENAUD ; C. HIBERT ; PH. FLUCKIGER ; G.-A. RACINE.** Modeling and Design of Low Voltage SOI Suspended-Gate MOSFET (SG-MOSFET) with a Metal-Over-Gate Architecture. *IEEE International Conference Symposium on Quality Electronic Design (ISQED,* 2002, 18-21
- **H. KAM ; D. T. LEE ; R. T. HOWE ; T-J. KING.** A new nano-electro-mechanical field effect transistor (NEMFET) design for low-power electronics. *IEDM Technical Digest,* 2005, 463-466
- **N. ABELÉ ; K. SÉGUÉNI ; K. BOUCART ; F. CASSET ; L. BUCHAILLOT ; P. ANCEY ; A.M. IONESCU.** Ultra-Low Voltage MEMS Resonator Based on RSG-MOSFET. *MEMS,* 2006, 882-885
- **N. ABELÉ ; A. VILLARET ; A. GANGADHARAIAH ; C. GABIOUD ; P. ANCEY ; A.M. IONESCU.** 1T MEMS memory based on suspended gate MOSFET. *IEDM,* 2006